(19) Europäisches Patentamt / European Patent Office / Office européen des brevets

(11) **EP 2 320 574 B1**

(12) **EUROPEAN PATENT SPECIFICATION**

(45) Date of publication and mention of the grant of the patent:
**09.10.2019 Bulletin 2019/41**

(51) Int Cl.:
**H03M 13/11** *(2006.01)* **H03M 13/47** *(2006.01)*

(21) Application number: **10003018.8**

(22) Date of filing: **22.03.2010**

(54) **Header encoding for single carrier (SC) and/or orthogonal frequency division multiplexing (OFDM) using shortening, puncturing, and/or repetition**

Anfangsblockcodierung für Einzelträger (SC-) und/oder orthogonalen Frequenzmultiplex (OFDM) unter Anwendung von Verkürzung, Durchlöcherung und/oder Wiederholung

Encodage d'embase pour transporteur unique et/ou multiplexage de division de fréquence orthogonale utilisant une réduction, perforation et/ou répétition

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **04.11.2009 US 612640**
**21.08.2009 US 235732 P**
**23.10.2009 US 605088**
**04.11.2009 US 612648**

(43) Date of publication of application:
**11.05.2011 Bulletin 2011/19**

(73) Proprietor: **Avago Technologies International Sales**
**Pte. Limited**
**Singapore 768923 (SG)**

(72) Inventors:
• **Trachewsky, Jason A.**
**Menlo Park, CA 94025 (US)**
• **Shen, Ba-Zhong**
**Irvine, CA 92606 (US)**

(74) Representative: **Bosch Jehle**
**Patentanwaltsgesellschaft mbH**
**Flüggenstraße 13**
**80639 München (DE)**

(56) References cited:
• **TAO TIAN ET AL: "Rate-compatible low-density parity-check codes", INFORMATION THEORY, 2004. ISIT 2004. PROCEEDINGS. INTERNATIONAL SYMPOS IUM ON CHICAGO, ILLINOIS, USA JUNE 27-JULY 2, 2004, PISCATAWAY, NJ, USA,IEEE, PISCATAWAY, NJ, USA, 27 June 2004 (2004-06-27), pages 153-153, XP010749864, DOI: 10.1109/ISIT.2004.1365190 ISBN: 978-0-7803-8280-0**
• **W.C. Huffman, Vera Pless: "Fundamentals of error-correcting codes", 2003, cambridge, XP002715810, * page 13 - page 18 ***
• **XIAOJIAN LIU, XIAOFU WU, CHUNMING ZHAO: "Shortening for Irregular QC-LDPC Codes", IEEE COMMUNICATIONS LETTERS, vol. 13, no. 8, 31 August 2009 (2009-08-31), [retrieved on 2018-01-29]**

**Description**

**TECHNICAL FIELD OF THE INVENTION**

The invention relates generally to encoding of a field within a frame to be transmitted within a communication systems; and, more particularly, it relates to encoding of header information within a communication device that is operative in accordance with one or both of single carrier (SC) or orthogonal frequency division multiplexing (OFDM) signaling within such communication systems.

**DESCRIPTION OF RELATED ART**

Data communication systems have been under continual development for many years. One such type of communication system that has been of significant interest lately is a communication system that employs iterative error correction codes (ECCs). Of particular interest is a communication system that employs LDPC (Low Density Parity Check) code. Communications systems with iterative codes are often able to achieve lower bit error rates (BER) than alternative codes for a given signal to noise ratio (SNR).

A continual and primary directive in this area of development has been to try continually to lower the SNR required to achieve a given BER within a communication system. The ideal goal has been to try to reach Shannon's limit in a communication channel. Shannon's limit may be viewed as being the data rate to be used in a communication channel, having a particular SNR, that achieves error free transmission through the communication channel. In other words, the Shannon limit is the theoretical bound for channel capacity for a given modulation and code rate.

LDPC code has been shown to provide for excellent decoding performance that can approach the Shannon limit in some cases. For example, some LDPC decoders have been shown to come within 0.3 dB (decibels) from the theoretical Shannon limit. While this example was achieved using an irregular LDPC code with a length of one million, it nevertheless demonstrates the very promising application of LDPC codes within communication systems.

The use of LDPC coded signals continues to be explored within many newer application areas. Some examples of possible communication systems that may employ LDPC coded signals include communication systems employing 4 wire twisted pair cables for high speed Ethernet applications (e.g., 10Gbps (Giga-bits per second) Ethernet operation according to the IEEE 802.3an (10GBASE-T) emerging standard) as well as communication systems operating within a wireless context (e.g., in the IEEE 802.11 context space including the IEEE 802.1 In emerging standard).

For any of these particular communication system application areas, near-capacity achieving error correction codes are very desirable. The latency constraints, which would be involved by using traditional concatenated codes, simply preclude their use in such applications in very high data rate communication system application areas.

Generally speaking, within the context of communication systems that employ LDPC codes, there is a first communication device at one end of a communication channel with encoder capability and second communication device at the other end of the communication channel with decoder capability. In many instances, one or both of these two communication devices includes encoder and decoder capability (e.g., within a bi-directional communication system). LDPC codes can be applied in a variety of additional applications as well, including those that employ some form of data storage (e.g., hard disk drive (HDD) applications and other memory storage devices) in which data is encoded before writing to the storage media, and then the data is decoded after being read/retrieved from the storage media.

**BRIEF SUMMARY OF THE INVENTION**

The present invention is directed to apparatus and methods of operation that are further described in the following Brief Description of the Several Views of the Drawings, the Detailed Description of the Invention, and the claims.

The invention is defined by the set of claims.

**BRIEF DESCRIPTION OF THE SEVERAL VIEWS OF THE DRAWINGS**

FIG. 1 and FIG. 2 illustrate various embodiments of communication systems.
FIG. 3 illustrates an embodiment of an LDPC (Low Density Parity Check) code bipartite graph.
FIG. 4A illustrates an embodiment of variable node update with reference to an LDPC code bipartite graph.
FIG. 4B illustrates an embodiment of check node update with reference to an LDPC code bipartite graph.
FIG. 5 illustrates an embodiment of a frame showing the respective portions of preamble, header, and data therein.
FIG. 6 illustrates an embodiment of an apparatus that is operative to process header information bits thereby generating a header.

FIG. 7 illustrates an embodiment of an apparatus that is operative to process header information bits thereby generating a header in accordance with an effective coding rate of 1/8 for use in a physical layer (PHY) frame to be transmitted in accordance with single carrier (SC) signaling.

FIG. 8 illustrates an embodiment of an apparatus that is operative to process header information bits thereby generating a header in accordance with an effective coding rate of 1/12 for use in a PHY frame to be transmitted in accordance with orthogonal frequency division multiplexing (OFDM) signaling.

FIG. 9 illustrates an embodiment of an apparatus that is operative to process header information bits thereby generating a header in accordance with an effective coding rate of K/N (K and N integers) for use in a PHY frame to be transmitted in accordance with SC signaling.

FIG. 10 illustrates an alternative embodiment of an apparatus that is operative to process header information bits thereby generating a header in accordance with an effective coding rate of 1/8 for use in a PHY frame to be transmitted in accordance with SC signaling.

FIG. 11, FIG. 12, and FIG. 13 illustrate various embodiments of an apparatus that is operative to process header information bits thereby generating a header, by employing selective puncturing, in accordance with an effective coding rate of 1/7 for use in a PHY frame to be transmitted in accordance with SC signaling.

FIG. 14 illustrates an embodiment of an apparatus that is operative to process header information bits thereby generating a header, by employing selective puncturing, in accordance with an effective coding rate of 9/56 for use in a PHY frame to be transmitted in accordance with SC signaling.

FIG. 15 illustrates an embodiment of performance comparisons of various LDPC codes, each employing a respective header encoding approach, using single carrier (SC) signaling with quadrature phase shift keying (QPSK) modulation on an additive white Gaussian noise (AWGN) communication channel.

FIG. 16 illustrates an embodiment of performance comparisons of various LDPC codes, each employing a respective header encoding approach, using SC signaling with an exponential decaying power delay profile (PDP) Rayleigh fading communication channel QPSK modulation.

FIG. 17 illustrates an embodiment of an apparatus that is operative to process header information bits thereby generating a header, by employing selective puncturing, in accordance with an effective coding rate of K/N (K and N integers) for use in a PHY frame to be transmitted in accordance with OFDM signaling.

FIG. 18 illustrates an embodiment of an apparatus that is operative to process header information bits thereby generating a header in accordance with an effective coding rate of 1/12 for use in a PHY frame to be transmitted in accordance with OFDM signaling.

FIG. 19, FIG. 20 and FIG. 21 illustrate various embodiments of an apparatus that is operative to process header information bits thereby generating a header, by employing selective puncturing, in accordance with an effective coding rate of 2/21 for use in a PHY frame to be transmitted in accordance with OFDM signaling.

FIG. 22 illustrates an embodiment of an apparatus that is operative to process header information bits thereby generating a header, by employing selective puncturing, in accordance with an effective coding rate of 3/28 for use in a PHY frame to be transmitted in accordance with OFDM signaling.

FIG. 23 illustrates an embodiment of performance comparisons of various LDPC codes, each employing a respective header encoding approach, using OFDM signaling with quadrature phase shift keying (QPSK) modulation on an AWGN communication channel.

FIG. 24 illustrates an embodiment of performance comparisons of various LDPC codes, each employing a respective header encoding approach, using OFDM signaling with an exponential decaying PDP Rayleigh fading communication channel QPSK modulation.

FIG. 25 illustrates an embodiment of an apparatus that is operative to process header information bits thereby generating a header, by employing selective puncturing including puncturing information bits in addition to parity/redundancy bits, in accordance with an effective coding rate of K/N (K and N integers) for use in a PHY frame to be transmitted in accordance with SC signaling.

FIG. 26 illustrates an embodiment of performance comparisons of various LDPC codes, each employing a respective header encoding approach, using SC signaling with QPSK modulation on an AWGN communication channel.

FIG. 27 illustrates an embodiment of performance comparisons of various LDPC codes, each employing a respective header encoding approach, using SC signaling with an exponential decaying PDP Rayleigh fading communication channel QPSK modulation.

FIG. 28A illustrates an embodiment of a method for processing header information bits thereby generating a header.

FIG. 28B illustrates an embodiment of an alternatively method for processing header information bits thereby generating a header.

## DETAILED DESCRIPTION OF THE INVENTION

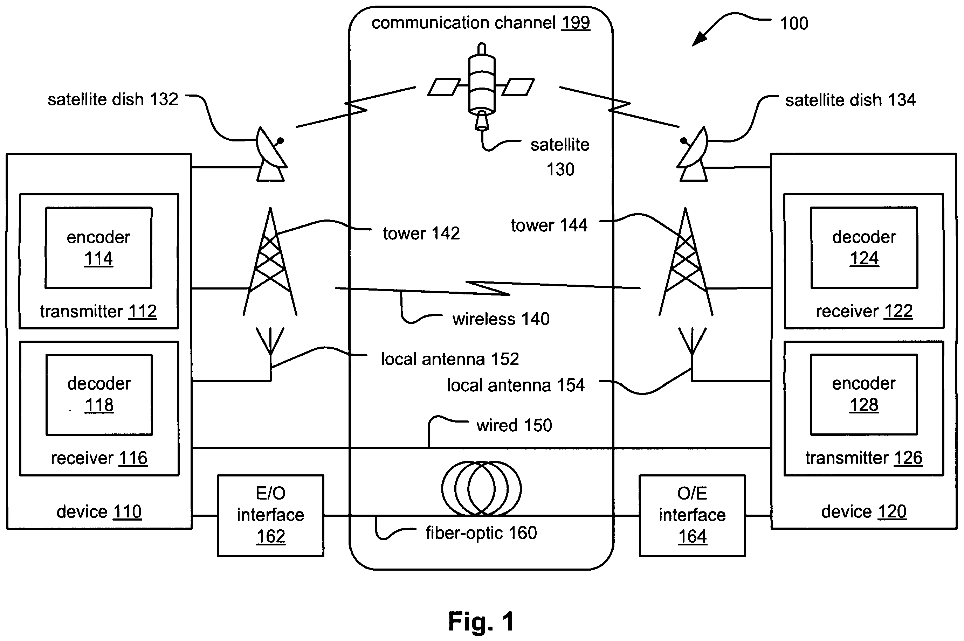

The goal of digital communications systems is to transmit digital data from one location, or subsystem, to another either error free or with an acceptably low error rate. As shown in FIG. 1, data may be transmitted over a variety of communications channels in a wide variety of communication systems: magnetic media, wired, wireless, fiber, copper, and other types of media as well.

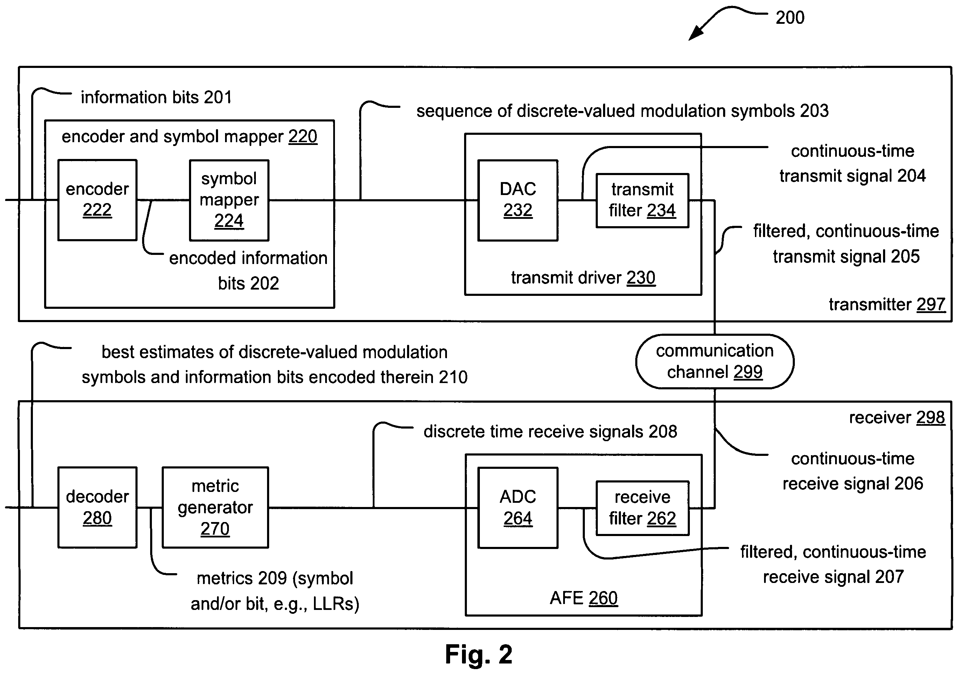

FIG. 1 and FIG. 2 are diagrams illustrate various embodiments of communication systems, 100 and 200, respectively.

Referring to FIG. 1, this embodiment of a communication system 100 is a communication channel 199 that communicatively couples a communication device 110 (including a transmitter 112 having an encoder 114 and including a receiver 116 having a decoder 118) situated at one end of the communication channel 199 to another communication device 120 (including a transmitter 126 having an encoder 128 and including a receiver 122 having a decoder 124) at the other end of the communication channel 199. In some embodiments, either of the communication devices 110 and 120 may only include a transmitter or a receiver. There are several different types of media by which the communication channel 199 may be implemented (e.g., a satellite communication channel 130 using satellite dishes 132 and 134, a wireless communication channel 140 using towers 142 and 144 and/or local antennae 152 and 154, a wired communication channel 150, and/or a fiber-optic communication channel 160 using electrical to optical (E/O) interface 162 and optical to electrical (O/E) interface 164)). In addition, more than one type of media may be implemented and interfaced together thereby forming the communication channel 199.

To reduce transmission errors that may undesirably be incurred within a communication system, error correction, and channel coding schemes are often employed. Generally, these error correction and channel coding schemes involve the use of an encoder at the transmitter and a decoder at the receiver. Of course, any such communication device implemented within such a communication system as described herein, or other type of communication system, may itself be transceiver type communication device that includes an encoder module therein for encoding signals to be transmitted (e.g., encoding information within signals), and also includes a decoder module therein for decoding signals that are received (e.g., decoding signals to make estimate of information encoded therein).

Any of the various types and embodiments of encoding and/or decoding described herein can be employed within any such desired communication system (e.g., including those variations described with respect to FIG. 1), any information storage device (e.g., hard disk drives (HDDs), network information storage devices and/or servers, etc.) or any application in which information encoding and/or decoding is desired.

Referring to the communication system 200 of FIG. 2, at a transmitting end of a communication channel 299, information bits 201 are provided to a transmitter 297 that is operable to perform encoding of these information bits 201 using an encoder and symbol mapper 220 (which may be viewed as being distinct functional blocks 222 and 224, respectively) thereby generating a sequence of discrete-valued modulation symbols 203 that is provided to a transmit driver 230 that uses a DAC (Digital to Analog Converter) 232 to generate a continuous-time transmit signal 204 and a transmit filter 234 to generate a filtered, continuous-time transmit signal 205 that substantially comports with the communication channel 299. At a receiving end of the communication channel 299, continuous-time receive signal 206 is provided to an AFE (Analog Front End) 260 that includes a receive filter 262 (that generates a filtered, continuous-time receive signal 207) and an ADC (Analog to Digital Converter) 264 (that generates discrete-time receive signals 208). A metric generator 270 calculates metrics 209 (e.g., on either a symbol and/or bit basis) that are employed by a decoder 280 to make best estimates of the discrete-valued modulation symbols and information bits encoded therein 210.

Moreover, one particular type of signal that is processed according to certain aspects and/or embodiments of the invention includes a frame composed of various fields including one of which that may be characterized as a header. Such header information included within a frame to be transmitted within a communication system in accordance with single carrier (SC) and/or orthogonal frequency division multiplexing (OFDM) signaling. This encoding of header information may be effectuated in accordance with shortening, puncturing, and/or repetition.

The decoders of either of the previous embodiments may be implemented to include various aspects and/or embodiment of the invention therein. In addition, several of the following Figures describe other and particular embodiments (some in more detail) that may be used to support the devices, systems, functionality and/or methods that may be implemented in accordance with certain aspects and/or embodiments of the invention. One particular type of signal that is processed according to certain aspects and/or embodiments of the invention is an LDPC coded signal. A general description of LDPC codes is provided below as well.

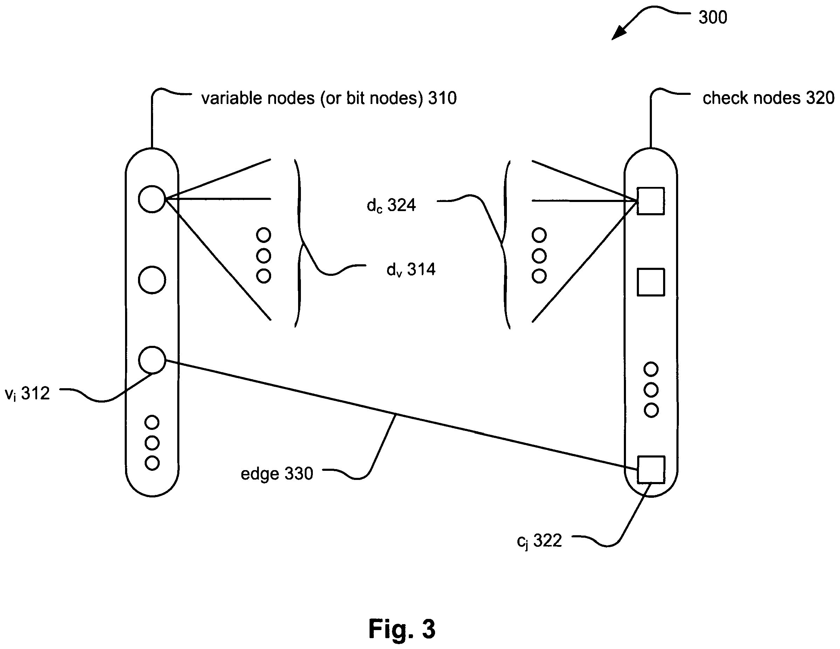

FIG. 3 illustrates an embodiment of an LDPC (Low Density Parity Check) code bipartite graph 300. In the art, an LDPC bipartite graph may also sometimes be referred to as a "Tanner" graph. An LDPC code may be viewed as being a code having a binary parity check matrix such that nearly all of the elements of the matrix have values of zeroes (e.g., the binary parity check matrix is sparse). For example, $H = (h_{i,j})_{M \times N}$ may be viewed as being a parity check matrix of an LDPC code with block length N.

LDPC codes are linear block codes and hence the set of all codewords $x \in C$ spans the null space of a parity check matrix, $H$.

$$Hx^T = 0, \ \forall x \in C \qquad\qquad (1)$$

For LDPC codes, $H$, is a sparse binary matrix of dimension $m \times n$. Each row of $H$ corresponds to a parity check and a set element $h_{ij}$ indicates that data symbol $j$ participates in parity check $i$. Each column of $H$ corresponds to a codeword symbol.

For each codeword $x$ there are $n$ symbols of which $m$ are parity symbols. Hence the code rate r is given by:

$$r = (n - m)/n \qquad\qquad (2)$$

The row and column weights are defined as the number of set elements in a given row or column of $H$, respectively. The set elements of $H$ are chosen to satisfy the performance requirements of the code. The number of 1's in the $i$-th column of the parity check matrix , $H$, may be denoted as $d_v(i)$, and the number of 1's in the $j$-th row of the parity check matrix may be denoted as $d_c(j)$. If $d_v(i)=d_v$ for all $i$, and $d_c(j) = d_c$ for all $j$, then the LDPC code is called a $(d_v, d_c)$ regular LDPC code, otherwise the LDPC code is called an irregular LDPC code.

LDPC codes were introduced by R. Gallager in [1] referenced below (also in [2] referenced below) and by M. Luby *et al.* in [3] also referenced below.

[1] R. Gallager, Low-Density Parity-Check Codes, Cambridge, MA: MIT Press, 1963.

[2] R. G. Gallager, "Low density parity check codes," IRE Trans. Info. Theory, vol. IT-8, Jan. 1962, pp. 21-28.

[3] M. G. Luby, M. Mitzenmacher, M. A. Shokrollahi, D. A. Spielman, and V. Stemann, "Practical Loss-Resilient Codes," Proc. 29th Symp. on Theory of Computing, 1997, pp. 150-159.

A regular LDPC code can be represented as a bipartite graph 300 by its parity check matrix with left side nodes representing variable of the code bits (or alternatively as the "variable nodes" (or "bit nodes") 310 in a bit decoding approach to decoding LDPC coded signals), and the right side nodes representing check equations (or alternatively as the "check nodes" 320). The **bipartite graph** 300 (or sometimes referred to as a Tanner graph 300) of the LDPC code defined by $H$ may be defined by $N$ variable nodes (e.g., $N$ bit nodes) and $M$ check nodes. Every variable node of the $N$ variable nodes 310 has exactly $d_v(i)$ edges (an example edge shown using reference numeral 330) connecting the bit node, $v_i$ 312, to one or more of the check nodes (within the M check nodes). The edge 330 is specifically shown as connecting from the bit node, $v_i$ 312, to the check node, $c_j$ 322. This number of $d_v$ edges (shown as $d_v$ 314) may be referred to as the **degree of a variable node** $i$. Analogously, every check node of the M check nodes 320 has exactly $d_c(j)$ edges (shown as $d_c$ 324) connecting this node to one or more of the variable nodes (or bit nodes) 310. This number of edges, $d_c$, may be referred to as the **degree of the check node** $j$.

An edge 330 between a variable node $v_i$ (or bit node $b_i$) 312 and check node $c_j$ 322 may be defined by $e = (i, j)$. However, on the other hand, given an edge $e = (i, j)$, the nodes of the edge may alternatively be denoted as by $e = (v(e), c(e))$ (or $e = (b(e), c(e))$). Alternatively, the edges in the graph correspond to the set elements of $H$ where a set element $h_{ji}$ indicates that an edge connects a bit (e.g., variable) node $i$ with parity check node $j$.

Given a variable node $v_i$ (or bit node $b_i$), one may define the set of edges emitting from the node $v_i$ (or bit node $b_i$) by $E_v(i) = \{e|v(e) = i\}$ (or by $E_b(i) = \{e|b(e) = i\}$); these edges are referred to as bit edges, and the messages corresponding to these bit edges are referred to as bit edge messages.

Given a check node $c_j$, one may define the set of edges emitting from the node $c_j$ by $E_c(j) = \{e|c(e) = j\}$; these edges are referred to as check edges, and the messages corresponding to these check edges are referred to as check edge messages. Continuing on, the derivative result will be $|E_v(i)| = d_v$ (or $|E_b(i)| = d_b$) and $|E_c(j)| = d_c$.

Generally speaking, any codes that can be represented by a bipartite graph may be characterized as a graph code. It is also noted that an irregular LDPC code may also described using a bipartite graph. However, the degree of each set of nodes within an irregular LDPC code may be chosen according to some distribution. Therefore, for two different variable nodes, $v_{i_1}$ and $v_{i_2}$, of an irregular LDPC code, $|E_v(i_1)|$ may not equal to $|E_v(i_2)|$ This relationship may also hold true for two check nodes. The concept of irregular LDPC codes was originally introduced within M. Luby *et al.* in [3] referenced above.

In general, with a graph of an LDPC code, the parameters of an LDPC code can be defined by a degree of distribution, as described within M. Luby *et al.* in [3] referenced above and also within the following reference [4]:

[4] T. J. Richardson and R. L. Urbanke, "The capacity of low-density parity-check code under message-passing decoding,'" IEEE Trans. Inform. Theory, Vol. 47, No. 2, Feb. 2001, pp. 599-618.

This distribution may be described as follows:

Let $\lambda_i$ represent the fraction of edges emanating from variable nodes of degree $i$ and let $\rho_i$ represent the fraction of edges

$$\lambda(x) = \sum_{i=2}^{M_v} \lambda_i x^{i-1}$$

emanating from check nodes of degree $i$. Then, a degree distribution pair ($\lambda$, $\rho$) is defined as follows:

$$\rho(x) = \sum_{i=2}^{M_c} \rho_i x^{i-1},$$

and where $M_v$ and $M_c$ represent the maximal degrees for variable nodes and check nodes, respectively.

While many of the illustrative embodiments described herein utilize regular LDPC code examples, it is noted that certain aspects and/or embodiments of the invention are also operable to accommodate both regular LDPC codes and irregular LDPC codes.

It is also noted that many of the embodiments described herein employ the terminology of "bit node" and "bit edge message", or equivalents thereof. Oftentimes, in the art of LDPC decoding, the "bit node" and "bit edge message" are alternatively referred to as "variable node" and "variable edge message", in that, the bit values (or variable values) are those which are attempted to be estimated. Either terminology can be employed in accordance with certain aspects of the invention.

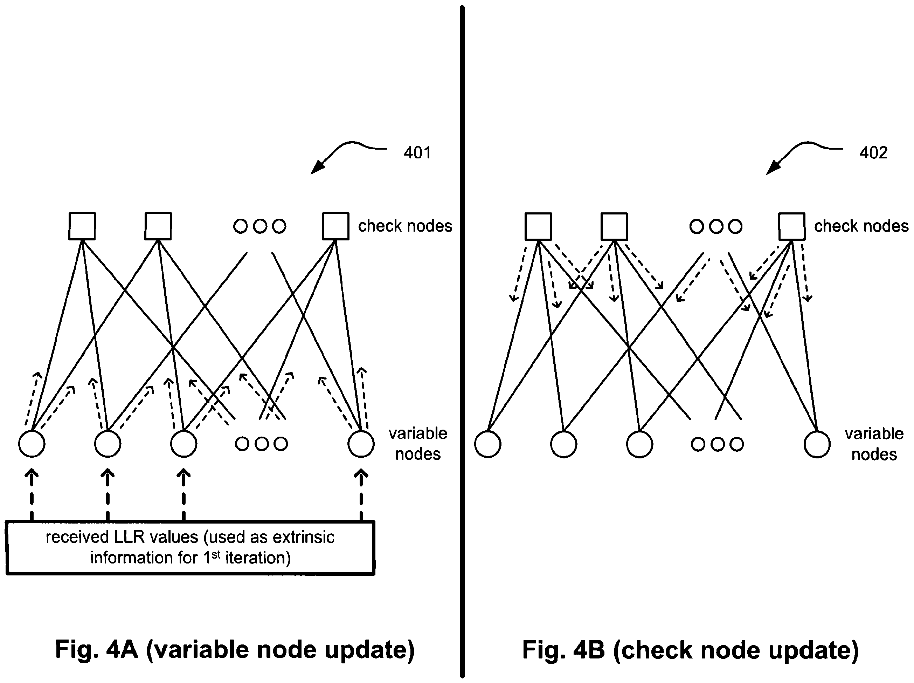

FIG. 4A illustrates an embodiment 401 of variable node update with reference to an LDPC code bipartite graph. FIG. 4B illustrates an embodiment 402 of check node update with reference to an LDPC code bipartite graph. These two diagrams may be considered in conjunction with one another.

A signal received from a communication channel undergoes appropriate demodulation (e.g., processing within an analog front end including digital sampling, filtering, gain adjustment, etc.) to generate a received bit sequence. Then, log-likelihood ratios (LLRs) are calculated for each bit location within the received bit sequence. These LLRs correspond respectively to bit nodes of the LDPC code and its corresponding LDPC bipartite graph.

During initialization, the LLRs are employed for the bit edge messages (e.g., extrinsic information) for each edge emanating from each respective variable node. Thereafter, check node processing or check node updating is performed using the original bit edge messages (e.g., the calculated LLRs). These updated check edge messages are then employed to perform bit node processing or bit node updating to update the variable node soft information for use in the next decoding iteration. The variable node soft information is then used to calculate the variable node edge messages (extrinsic information) for this next decoding iteration.

These variable node edge messages are then used in accordance with check node processing or check node updating to calculate updated check edge messages. Subsequently, these most recently updated check edge messages are then employed to perform bit node processing or bit node updating to update the variable node soft information once again.

After a final decoding iteration, which may be determined based on some parameter (e.g., a predetermined number of decoding iterations or when all syndromes of the LDPC code equal zero), the last calculated variable node soft information may undergo hard limiting (e.g., in a slicer) to generate estimates of the bits encoded within the received signal.

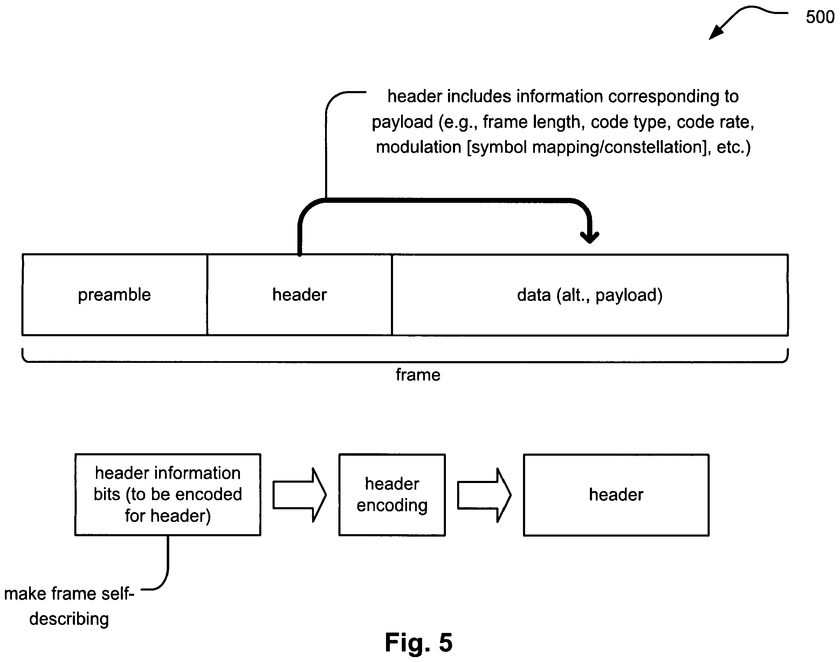

FIG. 5 illustrates an embodiment 500 of a frame showing the respective portions of preamble, header, and data therein. A frame, such as a physical layer frame, that gets transmitted from a communication device into a communication channel may have the form as described in this diagram. While many of the frames described herein are described with reference to a digital format, it is of course noted that a digital signal may undergo a variety of processing (e.g., digital to analog conversion, frequency conversion, filtering [analog or digital], scaling, etc.) to generate a continuous time signal that is launched into the communication channel.

In this diagram, the frame includes a preamble, a header, and data (alternatively referred to as the payload portion of the frame). The data generally includes the actually information to be transmitted from a first location to a second location.

The preamble includes a set of sequences (which may be repetitive) for a variety of applications including: initial frame/burst detection, carrier frequency acquisition, automatic gain control (AGC), timing recovery, channel estimation, noise/interference estimation, and/or information employed for other applications.

In one design, the preamble may be the same for both the single carrier (SC) modulation and orthogonal frequency division multiplexing (OFDM) PHY modes of operation. The preamble may be encoded as a set of Golay sequences (or other sequences with good correlation properties) encoded using BPSK followed by $\pm\pi/2$ (e.g., $\pm 90°$) rotation per symbol.

Header information bits undergo encoding (e.g., using the same type of code, or variant of the same base code, as is employed to encode the data) to form the "header". The header may be encoded/modulated using either SC modulation or OFDM. OFDM uses a certain number of data sub-carriers (e.g., 336) and a certain number of pilots/fixed sub-carriers (e.g., 16). In comparison, SC modulation may use binary phase shift keying (BPSK) modulation with $\pm\pi/2$

(e.g., ±90°) rotation per symbol. The header information bits (that undergo encoding to form the header) include all information required to make a frame self-describing. For example, the include information corresponding to modulation/coding set for the data field (e.g., code rate, code type, constellation/mapping, etc.), the length of the data in octets or time duration, and/or any additional training information (such as may be employed in accordance with beamforming in certain wireless contexts such as multiple input multiple output (MIMO) communication systems). The data field may be modulated using either SC modulation or OFDM using any of a variety of possible constellations and mappings.

A novel means is presented herein for generating the header that allows for providing a flexible header bits size for both SC (single carrier) and orthogonal frequency division multiplexing (OFDM) physical layer (PHY). The final output size of the header may be targeted to be a predetermined size (e.g., generally X bits, or specific values such as 448 bits for a SC PHY and 672 bits for an OFDM PHY. The OFDM header and SC header encodings are aligned (e.g., use the rate 3/4 of size 672 LDPC code as base code for both models).

In the OFDM PHY, the preamble is followed by the PLCP header (e.g., shown as header in the diagram). The PLCP header consists of several fields which define the details of the physical layer (PHY) protocol data unit (PPDU) being transmitted. The encoding and modulation of the header in accordance with any means or equivalent presented herein. Once embodiment of the header fields are described in the following Table relating to OFDM.

**Table OFDM - Header Fields**

| Field Name | Number of bits | Start Bit | Description |
|---|---|---|---|
| Scrambler Initialization | 7 | 0 | bits X1-X7 of the initial scrambler state. |
| MCS | 5 | 7 | Index into the Modulation and Coding Scheme table |
| Length | 18 | 12 | Number of data octets in the PSDU. Range 0-262143 |
| Additional PPDU | 1 | 30 | A value of 1 Indicates that this PPDU is immediately followed by another PPDU with no IFS or preamble on the subsequent PPDU. A value of 0 indicates that no additional PPDU follows this PPDU. |
| Packet Type | 2 | 31 | packet type:<br>0 - regular packet<br>1 - TRN-R packet<br>2 - TRN-T packet<br>3 - Reserved |
| Training Length | 5 | 33 | Length of the training field |
| Aggregation | 1 | 38 | Set to 1 to indicate that the PPDU in the data portion of the packet contains an AMPDU; otherwise, set to 0. |
| Reserved | 9 | 39 | Set to 0, ignored by receiver. |
| HCS | 16 | 48 | Header check sequence |

In this embodiment described above, all the numeric fields are encoded in unsigned binary, least significant bit first.

Alternatively, in an embodiment including the SC PHY, the preamble is followed by the PLCP header (e.g., shown as header in the diagram). The PLCP header consists of several fields which define the details of the physical layer (PHY) protocol data unit (PPDU) being transmitted. The encoding and modulation of the header in accordance with any means or equivalent presented herein. Once embodiment of the header fields are described in the following Table relating to the SCM PHY.

**Table SCM - Header Fields**

| Field Name | Number of bits | Start Bit | Description |
|---|---|---|---|
| Scrambler Initialization | 7 | 0 | Bits XI-X7 of the initial scrambler state |

(continued)

| Field Name | Number of bits | Start Bit | Description |
|---|---|---|---|
| MCS | 5 | 7 | Index into the Modulation and Coding Scheme table |
| Length | 18 | 12 | Number of data octets in the PSDU. Range 0-262143 |
| Additional PPDU | 1 | 30 | A value of 1 Indicates that this PPDU is immediately followed by another PPDU with no IFS or preamble on the subsequent PPDU. A value of 0 indicates that no additional PPDU follows this PPDU. |
| Packet Type | 2 | 31 | packet type:<br>0 - regular packet<br>1 - TRN-R packet<br>2 - TRN-T packet<br>3 - Reserved |
| Training Length | 4 | 33 | Length of the training field |
| Reserved | 1 | 37 | Set to 0, ignored by receiver. |
| Aggregation | 1 | 38 | Set to 1 to indicate that the PPDU in the data portion of the packet contains an AMPDU; otherwise, set to 0. |
| Reserved | 9 | 39 | Set to 0, ignored by receiver. |
| HCS | 16 | 48 | Header check sequence |

Also in this embodiment described above, all the numeric fields are encoded in unsigned binary, least significant bit first.

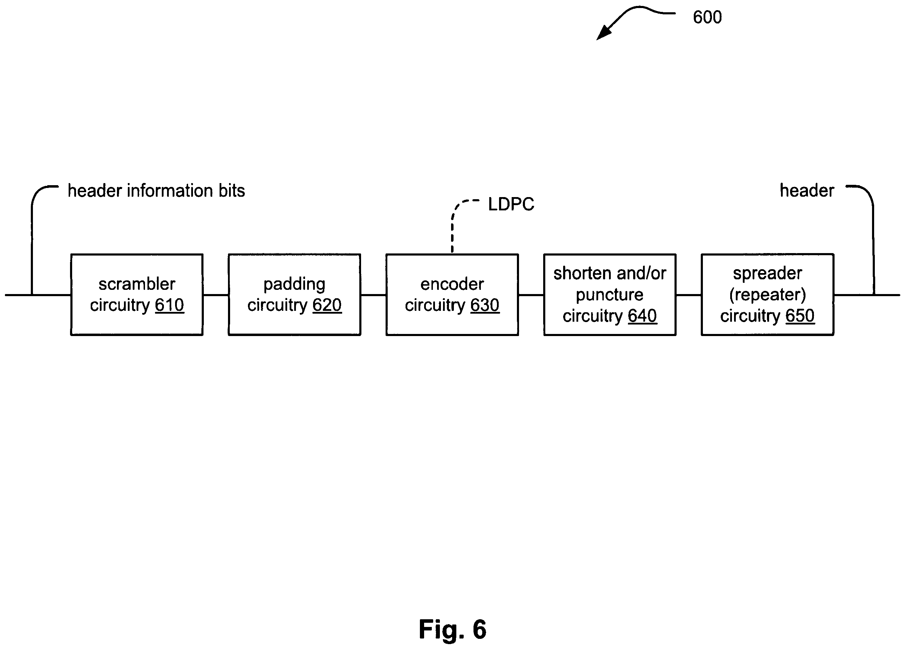

FIG. 6 illustrates an embodiment of an apparatus 600 that is operative to process header information bits thereby generating a header. Header information bits (e.g., those bits that includes all appropriate information to make the frame self-describing - such as those parameter described above) may be provided to a scrambler circuitry 610. After being scrambled in the scrambler circuitry 610 (using some scrambling pattern - one pattern/option of which may involve no scrambling whatsoever), these bits are then provided to a padding circuitry 620 that is operative to place at least one pad bit (e.g., a 0-valued bit) therein. The placement of where the at least one pad bit is emplaced within the bits provided to the padding circuitry 620 may be varied in different embodiments (e.g., at beginning, at end, interspersed throughout, etc.).

An encoder circuitry 630 operates by encoding padded bit block (output from the padding circuitry 620) thereby generating coded bits. Any of a variety of types of codes (e.g., an LDPC code) may be employed by the encoder circuitry 630. A shorten and/or puncture circuitry 640 may operate on the coded bits by shortening coded bits (e.g., removing padded bits) thereby generating shortened coded bits. The shortened and/or puncture circuitry 640 may also operate by puncturing at least one bit from the shortened coded bits thereby generating punctured bits. These punctured bits are passed to a spreader (repeater) 650 that is operative to perform spreading (e.g., combining, repeating, etc.) the punctured bits thereby generating a header to be emplaced within a frame to be transmitted from a communication device via a communication channel.

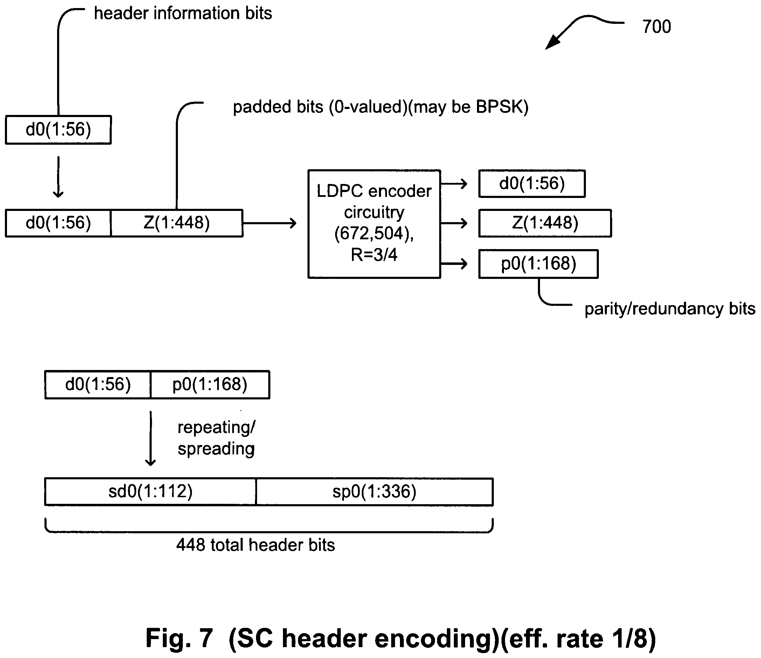

FIG. 7 illustrates an embodiment of an apparatus 700 that is operative to process header information bits thereby generating a header in accordance with an effective coding rate of 1/8 for use in a physical layer (PHY) frame to be transmitted in accordance with single carrier (SC) signaling. This diagram shows an encoding scheme for generating an SC header beginning with 56 header information bits such that the encoding is performed in accordance with an effective rate 1/8.

These 56 header information bits undergo scrambling. Thereafter, a certain number of bits are padded thereto, and these bits then undergo encoding with a (224,56) LDPC code that is generated by shortening a (672,504) rate ¾ LDPC code. After the padded bits are removed from the coded bits output from the LDPC encoder circuitry. A spreading/repeating of these remaining bits is made using factor of 2. The effective code rate is 56/448=1/8.

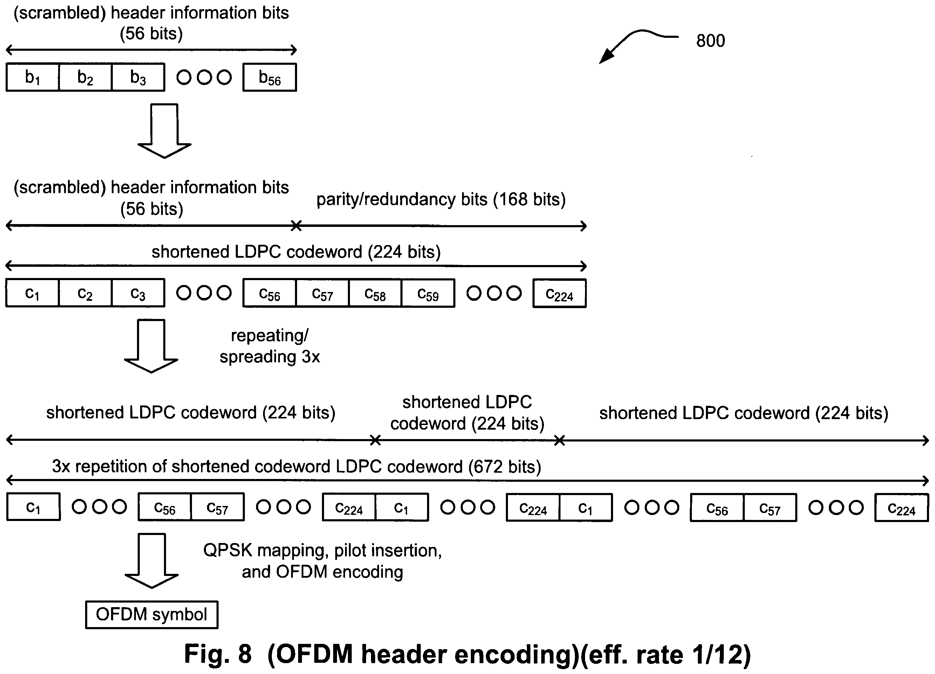

FIG. 8 illustrates an embodiment of an apparatus 800 that is operative to process header information bits thereby generating a header in accordance with an effective coding rate of 1/12 for use in a PHY frame to be transmitted in accordance with orthogonal frequency division multiplexing (OFDM) signaling. In some respects, the header encoding is similar to the previous embodiment described with reference to FIG. 7, with at least one difference being that the spreading/repetition is performed using a factor of 3 (vs. 2 of the previous embodiment). This diagram shows an encoding scheme for generating an OFDM header that is generated beginning with 56 information bits and operates in accordance with an effective rate of 1/12.

In some embodiments, it may be desirable to employ more header information bits (e.g., more than 56 header information bits). For example, in some embodiments, to include information to describe all of the details corresponding to the date of the frame, a larger number of header information bits may be required.

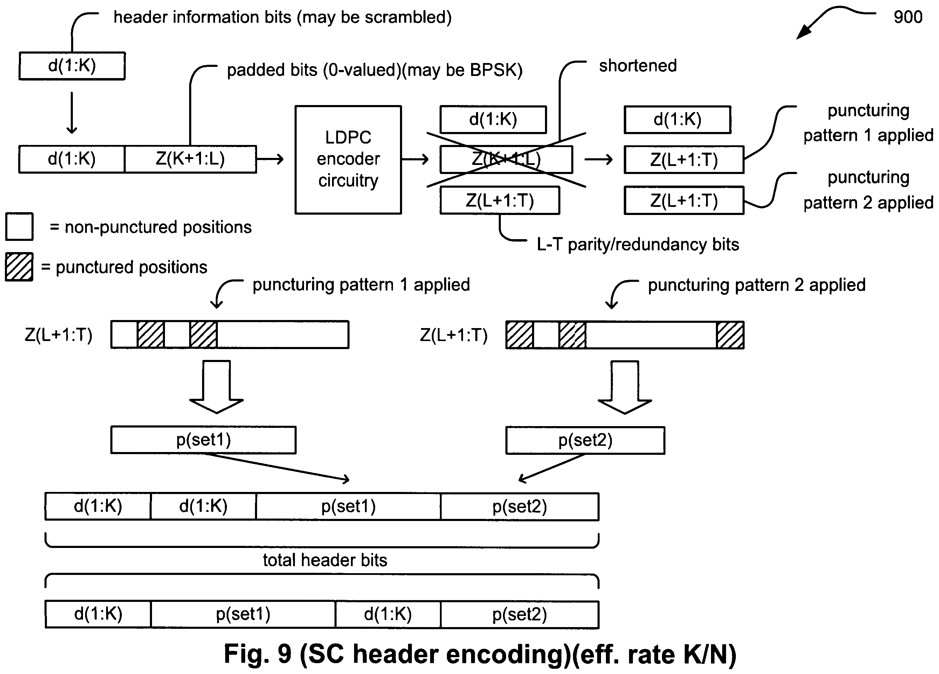

FIG. 9 illustrates an embodiment of an apparatus 900 that is operative to process header information bits thereby generating a header in accordance with an effective coding rate of K/N (K and N integers) for use in a PHY frame to be transmitted in accordance with SC signaling. In certain of the previous embodiments, only shortening and repetition are employed. However, selective puncturing is also employed herein, and that puncturing is applied in a manner that allows for a relatively low performance impact of the encoding performed in the generation of the header.

For example, when more header information bits are employed (e.g., those bits that include the information that are operative to make a frame self-describing), and when a fixed output size of the eventually generated header is desirable while still employing the same base LDPC code, then selective puncturing may also be performed in accordance with the header encoding technique to the header encoding scheme. This selective puncturing may employ multiple puncturing patterns as applied to various portions of a group of bits. For example, the selective puncturing may be applied to parity/redundancy bits, to copies/duplicated portions of those parity/redundancy bits (as may be generated in accordance with repetition/spreading), to the original header information bits themselves, and/or to copies/duplicated portions of those information bits themselves.

SC PHY header

Rather than employing a 2 time repetition of a single shortened LDPC codeword (e.g., as generated by an LDPC encoder), 2 copies of shortened and punctured LDPC codewords with 2 different puncturing patterns applied thereto may instead be employed. Of course, generally speaking, N copies of shortened and punctured LDPC codewords with N different puncturing patterns applied thereto may instead be employed (N being an integer).

OFDM PHY header

Rather than employing a 3 time repetition of a single shortened LDPC codeword (e.g., as generated by an LDPC encoder), 3 copies of shortened and punctured LDPC codewords with 3 different puncturing patterns applied thereto may instead be employed. Of course, generally speaking, N copies of shortened and punctured LDPC codewords with N different puncturing patterns applied thereto may instead be employed (N being an integer).

With respect to any embodiment of the SC PHY header and OFDM PHY header presented herein, it is noted that any desired means of combination of the bits may be made to generate the final header (e.g., rearranging of the bits in accordance with scrambling, interleaving, etc. including switching the order of any two or more bits; the order in which the header information bits, the remaining/non-punctured bits [whether they be header information bits or parity/redundancy bits] may be emplaced in the final formed header in accordance with any desired manner or order as a particular embodiment or implementation would prefer or require. For example, while many of the embodiments presented herein, the header information bits (which are repeated) are followed by the parity/redundancy bits (which are also repeated). However, the order in which these bits are included to form the final header may also be changed without departing from the scope and spirit of the invention (e.g., parity/redundancy bits firstly followed by the header information bits; alternatively: header information bits followed by parity/redundancy bits then followed by a copy/duplicate of the header information bits then followed by a copy/duplicate of the parity/redundancy bits).

Decoding

In a receiver communication device, a same decoder that is operative to perform decoding of a base LDPC code may also be employed to perform header decoding of each of a SC PHY header and an OFDM PHY header. In other words, by appropriate design and implementation of the headers (be they in accordance with SC or OFDM signaling), a single decoder may be provisioned to decode not only the various types of headers generated thereby but also the data portions of corresponding frames that have been generated in accordance with LDPC encoding as well.

In accordance with decoding, metrics or log-likelihood ratios (LLRs) (e.g., see metric generation operations with reference to FIG. 2) of repetition bits are combined (summed) with a proper scaling. Because different puncturing patterns are applied to different portions of a group of bits (e.g., that applies a first puncturing pattern to the original portion of the group of bits and a second puncturing pattern to a copied/duplicated portion of the group of bits), then intelligent combination of the LLRs may be made to recoup any coding loss that may have been incurred by the puncturing applied.

In accordance with decoding processing, the LLRs of shortened bits are known (e.g., because they correspond to bits have predetermined values such as being 0-valued bits). As such, they may be assigned to a fixed/predetermined value. Because all of the shortened bits are typically assigned a common value (e.g., bit value of 0), the LLRs corresponding thereto may all be assigned to the same fixed/predetermined value.

However, because the values of the punctured bits are unknown, the LLRs corresponding thereto are unknown and may all be assigned a predetermined value (e.g., 0). However, by using the different puncturing patterns for different repetition blocks, any unknown LLR may be avoided after combining with LLRs generated by other repetition blocks.

With these new approaches, comparing to the previous art the new encoding schemes with longer information bits will have better or equal performance after offsetting the effective code rate gain.

In the embodiment of FIG. 9, certain parameters are given including: the output size of SC header encoding = N bits (e.g., N = 448), and the rate R (L,T) LDPC code, say LDPC(R), where L is the block size and T is the size of information bits.

The K header information bits (where $K \leq T$) may undergo scrambling thereby generating the bits $d(1),...,d(K)$ that then undergo padding. After padding T-K 0 bits thereto (e.g., shown as $z(K+1),...,z(T)$ 0-valued bits that are padded after the K information bits (shortening)), then these K header information bits and the padded bits are provided to an LDPC encoder circuitry. Of course, it is noted that zero-valued bits (e.g., padded bits) are not transmitted via the communication channel (e.g., on the air in a wireless communication channel embodiment).

The LDPC encoder circuitry is operative to encode $d(1),...,d(K),z(K+1),...,z(T)$ using an LDPC code, LDPC(R), to get L-T parity/redundancy bits, shown as $p(1),...,p(L-T)$.

Two separate and distinct puncturing patterns are employed, depicted as punc[1] and punc[2], respectively, on L-T parity bits, respectively, to get two sub-sequences of parity bits, say $p(set1)=\{p(i_1),p(i_2),...,p(i_a)\}$, $p(set2)=\{p(j_1),p(j_2),...,p(j_b)\}$ such that $2 \times K+a+b=N$. It is noted that punc[1] is a subset of $\{1,...,L-T\}$ of size L-T-a, and punc[2] is a subset of $\{1,...,L-T\}$ of size L-T-b. The output duplicated information bits, e.g., $d(1),...,d(K),d(1),...,d(K)$, are followed by p(set1) and p(set2). The effective code rate of such a header encoding approach is K/N.

While this embodiment shows an example of combining the bits (e.g., using a spreading circuitry) to generate the header by employing the information bits, e.g., $d(1),...,d(K),d(1),...,d(K)$, are followed by p(set1) and p(set2), as described above, with respect to any embodiment of the SC PHY header and OFDM PHY header presented herein. In an alternative embodiment, the header is generated by employing the information bits, e.g., $d(1),...,d(K)$ followed by p(set1), followed by a duplicate of the information bits, $d(1),...,d(K)$, and then followed by p(set2).

It is again noted that any desired means of combination of the bits may be made to generate the final header (e.g., rearranging of the bits in accordance with scrambling, interleaving, etc. including switching the order of any two or more bits; the order in which the header information bits, the remaining/non-punctured bits [whether they be header information bits or parity/redundancy bits] may be emplaced in the final formed header in accordance with any desired manner or order as a particular embodiment or implementation would prefer or require. For example, while many of the embodiments presented herein, the header information bits (which are repeated) are followed by the parity/redundancy bits (which are also repeated). However, the order in which these bits are included to form the final header may also be changed without departing from the scope and spirit of the invention (e.g., parity/redundancy bits firstly followed by the header information bits; alternatively: header information bits followed by parity/redundancy bits then followed by a copy/duplicate of the header information bits then followed by a copy/duplicate of the parity/redundancy bits).

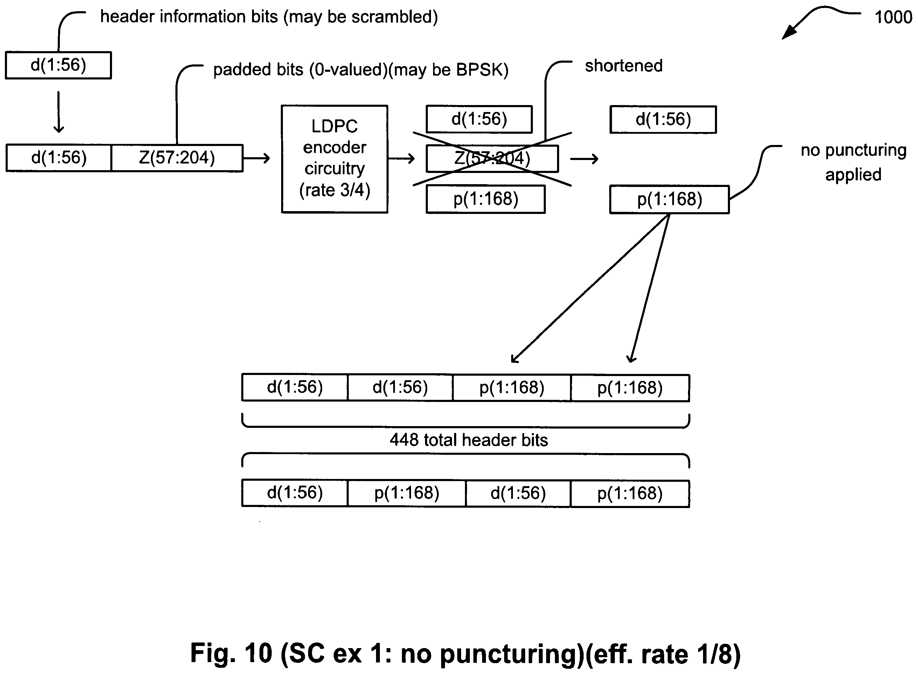

FIG. 10 illustrates an alternative embodiment of an apparatus 1000 that is operative to process header information bits thereby generating a header in accordance with an effective coding rate of 1/8 for use in a PHY frame to be transmitted in accordance with SC signaling. This embodiment employs no puncturing therein, and consequently no selective puncturing therein that applied different puncturing patterns to different portions of the block. This embodiment may be referred to as SC header encoding example 1 as having an effective rate 1/8, K=56, N=448, (672,504) LDPC code. Again, no puncturing is performed in this embodiment, i.e. punc[1]=punc[2]=Ø.

One embodiment forms the header (e.g., by using a spreader circuitry) by employing the information bits, e.g., $d(1),...,d(56), d(1),...,d(56)$, followed by $p(1),...,p(168)$ and $p(1),...,p(168)$. However, in an alternative embodiment, the header is generated by employing the information bits, e.g., $d(1),...,d(56)$ followed by $p(1),...,p(168)$, then followed by a duplicate of the information bits, $d(1),...,d(56)$, and then followed by $p(1),...,p(168)$. Again, any desired means of combination of the bits may be made to generate the final header.

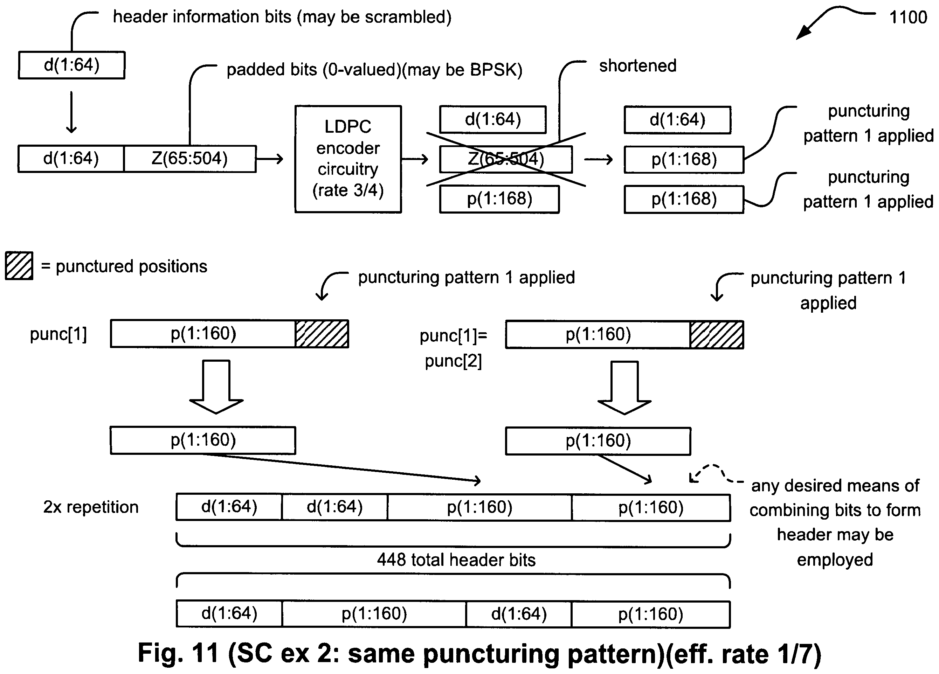

FIG. 11, FIG. 12, and FIG. 13 illustrate various embodiments of an apparatus 1100, 1200, and 1300, respectively, that is operative to process header information bits thereby generating a header, by employing selective puncturing, in accordance with an effective coding rate of 1/7 for use in a PHY frame to be transmitted in accordance with SC signaling.

Referring to embodiment 1100 of FIG. 11, a greater number of header information bits are employed than in certain previous embodiments (e.g., 64 header information bits vs. 56 header information bits). In addition, puncturing of selected bits is performed in this embodiment 1100. A common puncturing pattern is applied to different portions thereof.

This embodiment 1100 may be referred to as SC header encoding example 2 as having an effective rate 1/7, K=64, N=448, (672,504) LDPC code. As can be seen, a common puncturing pattern, depicted as punc[1]=punc[2]={161,162,...,168}, is applied to the parity/redundancy bits and the duplicate copy generated there from.

In other embodiments, certain of the header information bits themselves may also undergo puncturing (as also presented below in other embodiments). Again, in this embodiment 1100 as well as in any embodiment presented herein, any desired means of combination of the bits may be made to generate the final header.

One embodiment forms the header (e.g., by using a spreader circuitry) by employing the information bits, e.g., d(1),...,d(64), d(1),...,d(64), followed by p(1),...,p(160) and p(1),...,p(160). However, in an alternative embodiment, the header is generated by employing the information bits, e.g., d(1),...,d(64) followed by p(1),...,p(160), then followed by a duplicate of the information bits, d(1),...,d(64), and then followed by p(1),...,p(160). Again, any desired means of combination of the bits may be made to generate the final header.

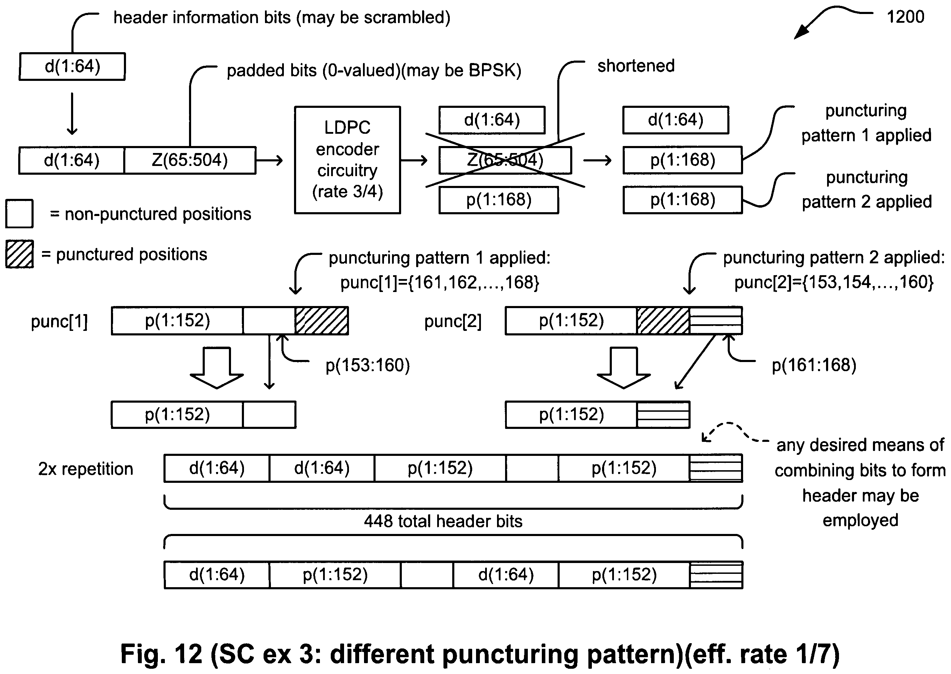

Referring to embodiment 1200 of FIG. 12, a greater number of header information bits are employed than in certain previous embodiments (e.g., 64 header information bits vs. 56 header information bits). In addition, puncturing of selected bits is performed in this embodiment 1200. At least two separate and distinct puncturing patterns are applied to different portions thereof.

This embodiment 1200 may be referred to as SC header encoding example 3 as having an effective rate 1/7, K=64, N=448, (672,504) LDPC code. As can be seen, two separate and distinct puncturing patterns, depicted as punc[1]={161,162,...,168}, and punc[2]={153,154,...,160}, respectively, are applied to the parity/redundancy bits and the duplicate copy generated there from. After puncturing, the remaining/non-punctured bits are composed of p(153:160) and p(161:168), respectively.

This embodiment 1200 shows the puncturing being performed therein to use consecutive puncturing. For example, a consecutive/contiguous group of bits are punctured.

In other embodiments, certain of the header information bits themselves may also undergo puncturing (as also presented below in other embodiments). Again, in this embodiment as well as in any embodiment presented herein, any desired means of combination of the bits may be made to generate the final header.

One embodiment forms the header (e.g., by using a spreader circuitry) by employing the information bits, e.g., d(1),...,d(64),d(1),...,d(64), followed by p(1),...,p(152), followed by p(153),...,p(160), and p(1),...,p(152), followed by p(161),...,p(168). However, in an alternative embodiment, the header is generated by employing the information bits, e.g., d(1),...,d(64) followed by p(1),...,p(152), followed by p(153),...,p(160), then followed by a duplicate of the information bits, d(1),...,d(64), and then followed by p(1),...,p(152), followed by p(161),...,p(168). Again, any desired means of combination of the bits may be made to generate the final header.

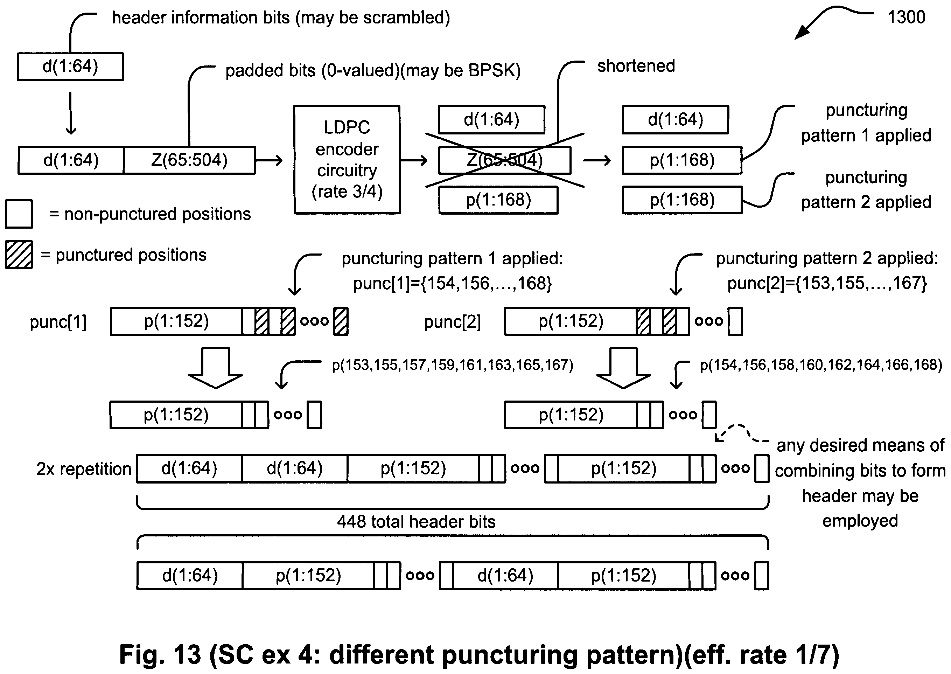

Referring to embodiment 1300 of FIG. 13, a greater number of header information bits are employed than in certain previous embodiments (e.g., 64 header information bits vs. 56 header information bits). In addition, puncturing of selected bits is performed in this embodiment 1200. At least two separate and distinct puncturing patterns are applied to different portions thereof.

This embodiment may be referred to as SC header encoding example 4 as having an effective rate 1/7, K=64, N=448, (672,504) LDPC code. As can be seen, two separate and distinct puncturing patterns, punc[1]={154,156,...,168}, punc[2]={153,155,...,167}, respectively, are applied to the parity/redundancy bits and the duplicate copy generated there from.

After puncturing, the remaining/non-punctured bits are composed of p(153,155,157,159,161,163,165,167) and p(154,156,158,160,162,164,166,168), respectively.

This embodiment 1300 shows the puncturing being performed therein to use non-consecutive puncturing. For example, a non-consecutive/non-contiguous group of bits are punctured. Different non-consecutive/non-contiguous portions of the parity/redundancy bits and the duplicate copy thereof undergo puncturing.

Again, in other embodiments, certain of the header information bits themselves may also undergo puncturing (as also presented below in other embodiments). Also, in this embodiment as well as in any embodiment presented herein, any desired means of combination of the bits may be made to generate the final header.

One embodiment forms the header (e.g., by using a spreader circuitry) by employing the information bits, e.g., d(1),...,d(64),d(1),...,d(64), followed by p(1),...,p(152), followed by p(153,155,157,159,161,163,165,167), and p(1),...,p(152), followed by p(154,156,158,160,162,164,166,168). However, in an alternative embodiment, the header is generated by employing the information bits, e.g., d(1),...,d(64) followed by p(1),...,p(152), followed by p(153,155,157,159,161,163,165,167), then followed by a duplicate of the information bits, d(1),...,d(64), and then followed by p(1),...,p(152), followed by p(154,156,158,160,162,164,166,168). Again, any desired means of combination of the bits may be made to generate the final header.

In accordance with the header encoding presented herein, certain embodiments that perform header encoding (e.g., scrambled and encoded) using a single SCM block may be described as described below. The header will be encoded using a single SCM block of $N_{CBPB}$ symbols with $N_{GI}$ guard symbols. The bits are scrambled and encoded as follows:

(1) The input header bits ($b_1$, $b_2$, ..., $b_{LH}$), where LH = 64, are scrambled, starting from the eighth bit. to create

$d_{1s}=(q_1,q_2,...,q_{LH})$

(2) The LDPC codeword c = $(q_1,q_2,...,q_{LH},0_1,0_2,...,0_{504-LH},p_1,p_2,...,p_{168})$ is created by concatenating 504-LH zeros to the LH bits of $d_{1s}$ and then generating the parity bits $p_1,p_2,...,p_{168}$ such that $Hc^T = 0,$ where H is the parity check matrix for the rate 3/4 LDPC code.

(3) Remove bits LH+1 through 504 and bits 665 through 672 of the codeword c to create the sequence $cs1=(q_1,q_2,...,q_{LH},p_1,p_2,...,p_{160}).$

(4) Remove bits LH+1 through 504 and bits 657 through 664 of the codeword c and then XORed with the one-time pad sequence (starting from left and with the LSB the first to be used in each nibble) to create the sequence $cs2=(q_1,q_2,...,q_{LH},p_1,p_2,...,p_{152},p_{161},p_{162},...,p_{168}).$

(5) cs1 and cs2 are concatenated to form the sequence (csl, cs2). The resulting 448 bits are then mapped as $\pi/2$-BPSK. The $N_{GI}$ guard symbols are then pre-pended to the resulting $N_{CBPB}$ symbols.

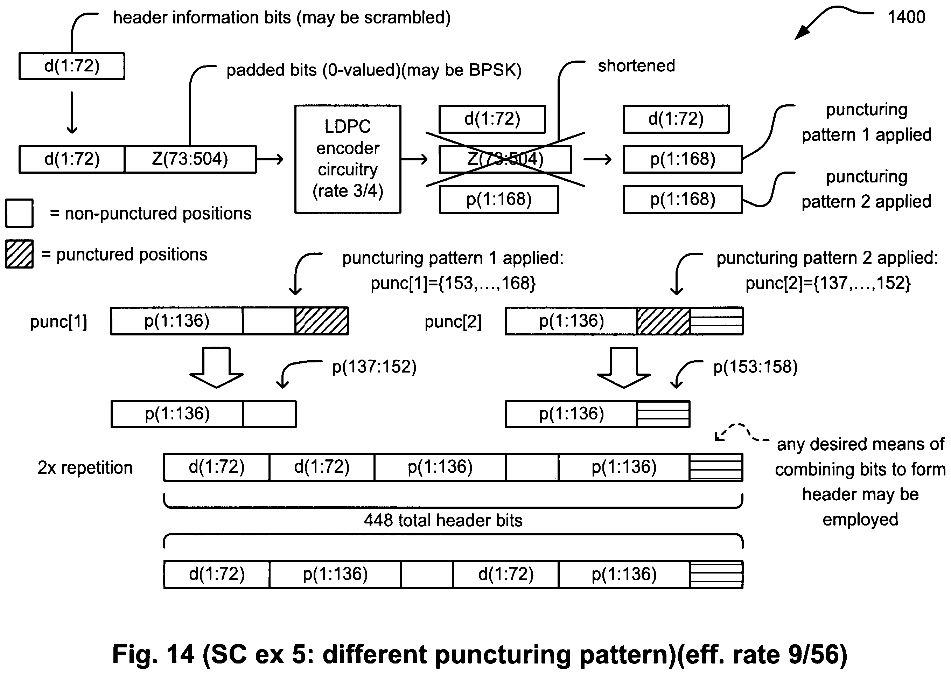

FIG. 14 illustrates an embodiment of an apparatus 1400 that is operative to process header information bits thereby generating a header, by employing selective puncturing, in accordance with an effective coding rate of 9/56 for use in a PHY frame to be transmitted in accordance with SC signaling.

In this embodiment 1400, an even greater number of header information bits are employed than in certain previous embodiments (e.g., 72 header information bits vs. 64 header information bits or 56 header information bits). In addition, puncturing of selected bits is performed in this embodiment 1400. At least two separate and distinct puncturing patterns are applied to different portions thereof.

This embodiment may be referred to as SC header encoding example 5 (employing K=72 header information bits) as having an effective rate 9/56, K=72, N=448, (672,504) LDPC code. As can be seen, two separate and distinct puncturing patterns, punc[1]={153:168}, punc[2]={137:152}, respectively, are applied to the parity/redundancy bits and the duplicate copy generated there from.

After puncturing the 16 positions in each of the parity/redundancy bits and the duplicate copy generated there from, the remaining/non-punctured bits are composed of p(137:152) and p(153:168), respectively.

This embodiment 1400 shows the puncturing being performed therein to use consecutive puncturing. For example, a consecutive/contiguous group of bits are punctured.

In other embodiments, certain of the header information bits themselves may also undergo puncturing (as also presented below in other embodiments). Again, in this embodiment as well as in any embodiment presented herein, any desired means of combination of the bits may be made to generate the final header.

One embodiment forms the header (e.g., by using a spreader circuitry) by employing the information bits, e.g., d(1),...,d(72),d(1),...,d(72), followed by p(1),...,p(136), followed by p(137:152), and p(1),...,p(136), followed by p(153:158). However, in an alternative embodiment, the header is generated by employing the information bits, e.g., d(1),...,d(64) followed by p(1),...,p(136), followed by p(137:152), then followed by a duplicate of the information bits, d(1),...,d(64), and then followed by p(1),...,p(136), followed by p(153:158). Again, any desired means of combination of the bits may be made to generate the final header.

Oftentimes performance diagrams are described in the context of BLER (Block Error Rate) [or BER (Bit Error Rate)] versus $E_b/N_o$ (ratio of energy per bit $E_b$ to the Spectral Noise Density $N_o$) or SNR (Signal to Noise Ratio). This term $E_b/N_o$ is the measure of SNR for a digital communication system. When looking at such performance curves, the BLER [or BER] may be determined for any given $E_b/N_o$ (or SNR) thereby providing a relatively concise representation of the performance of the decoding approach.

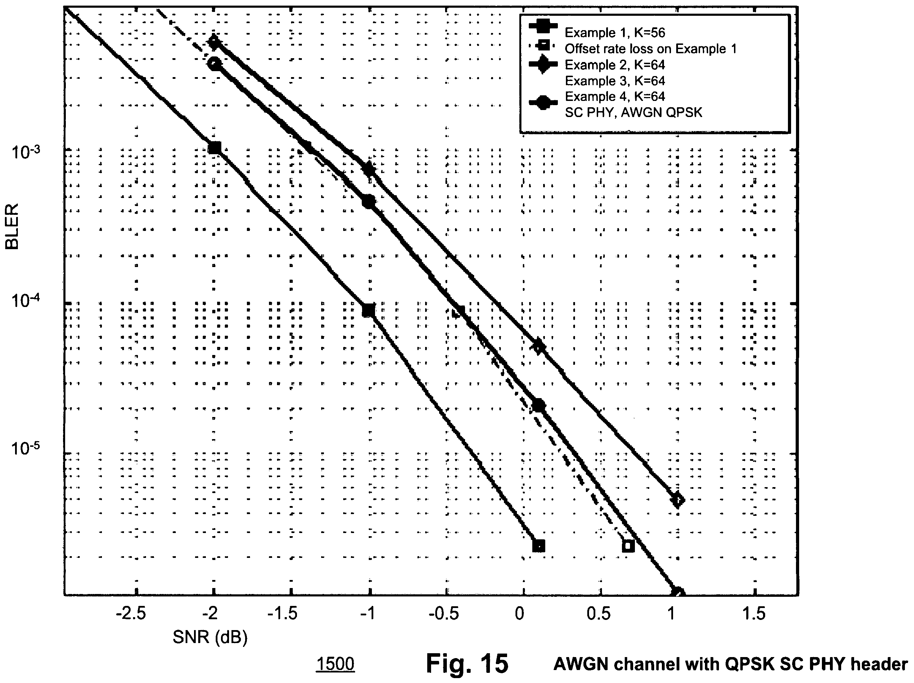

FIG. 15 illustrates an embodiment 1500 of performance comparisons of various LDPC codes, each employing a respective header encoding approach, using single carrier (SC) signaling with quadrature phase shift keying (QPSK) modulation on an additive white Gaussian noise (AWGN) communication channel.

The various examples 1, 2, 3, and 4 presented in certain of the previous diagrams are shown in this diagram to show the relative performance thereof based on a AWGN communication channel.

To compensate for the coding offset incurred by the different effective coding rate of 1/8 (corresponding to example 1) when compared to the effective coding rate of 1/7 (corresponding to examples 2, 3, and 4), the performance curve of example 1 is shifted appropriately to allow for an accurate comparison.

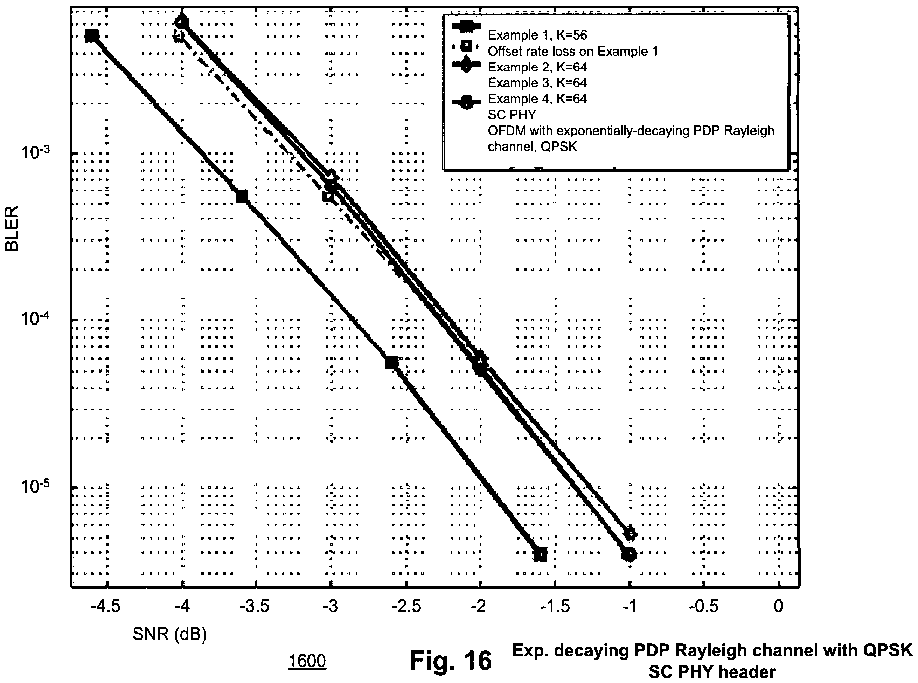

FIG. 16 illustrates an embodiment 1600 of performance comparisons of various LDPC codes, each employing a respective header encoding approach, using SC signaling with an exponential decaying power delay profile (PDP) Rayleigh fading communication channel QPSK modulation.

The various examples 1, 2, 3, and 4 presented in certain of the previous diagrams are shown in this diagram to show the relative performance thereof based on an exponential decaying PDP Rayleigh fading communication channel QPSK modulation.

Again, as with the previous embodiment 1500, to compensate for the coding offset incurred by the different effective coding rate of 1/8 (corresponding to example 1) when compared to the effective coding rate of 1/7 (corresponding to examples 2, 3, and 4), the performance curve of example 1 is shifted appropriately to allow for an accurate comparison.

Performance analysis for SC header

A net coding gain or loss may be incurred when considering the rate loss of 1/8 comparing to 1/7. However, the net coding gain or loss of the effective rate 1/8 codes is of course offset by approximately 10log10((1/7)/(1/8))=0.58 dB (e.g., see doted curves in the performance diagrams as referenced above).

In comparing to the effective rate 1/8 code (e.g., example 1) and the effective rate 1/7 codes (e.g., examples 2, 3, and 4) on an AWGN channel, the following observations may be made. Example 3 and 4 have no net performance loss. Example 2 has net 0.25 dB performance loss. An absolute (not counting rate gain) SNR loss of Example 3 and 4 is 0.58 dB.

In comparing to the effective rate 1/8 code (e.g., example 1) and the effective rate 1/7 codes (e.g., examples 2, 3, and 4) on OFDM with exponentially-decaying PDP Rayleigh channel, the following observations may be made. Examples 2, 3 and 4 all have no net performance loss. An absolute (not counting rate gain) SNR loss of Examples 2, 3 and 4 is 0.58 dB.

OFDM header encoding scheme

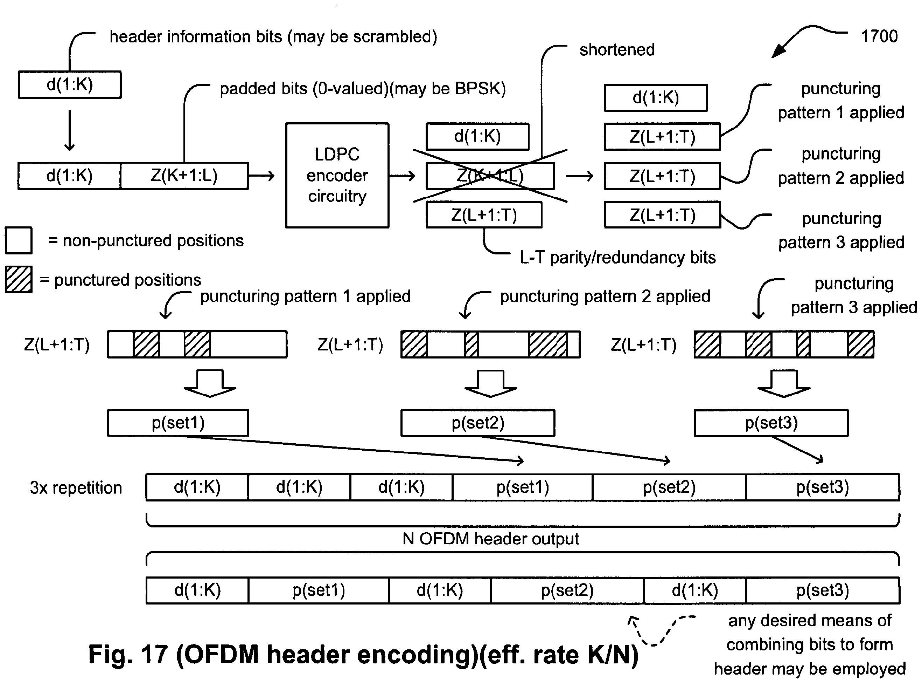

FIG. 17 illustrates an embodiment 1700 of an apparatus that is operative to process header information bits thereby generating a header, by employing selective puncturing, in accordance with an effective coding rate of K/N (K and N integers) for use in a PHY frame to be transmitted in accordance with OFDM signaling.

Again, when more header information bits are employed (e.g., those bits that include the information that are operative to make a frame self-describing), and when a fixed output size of the eventually generated header is desirable while still employing the same base LDPC code, then selective puncturing may also be performed in accordance with the header encoding technique to the header encoding scheme. This selective puncturing may employ multiple puncturing patterns as applied to various portions of a group of bits. For example, the selective puncturing may be applied to parity/redundancy bits, to copies/duplicated portions of those parity/redundancy bits (as may be generated in accordance with repetition/spreading), to the original header information bits themselves, and/or to copies/duplicated portions of those information bits themselves.

In accordance with OFDM signaling, certain operational parameters may be defined including: output size of OFDM header encoding, say N; rate R (L,T) LDPC code, say LDPC(R), where L is the block size and T is the size of information bits.

The K header information bits (where $K \leq T$) may undergo scrambling thereby generating $d(1),...,d(K)$ that then undergo padding.

The K header information bits (where $K \leq T$) may undergo scrambling thereby generating the bits $d(1),...,d(K)$ that then undergo padding. After padding T-K 0 bits thereto (e.g., shown as $z(K+1),...,z(T)$ 0-valued bits that are padded after the K information bits (shortening)), then these K header information bits and the padded bits are provided to an LDPC encoder circuitry. Of course, it is noted that zero-valued bits (e.g., padded bits) are not transmitted via the communication channel (e.g., on the air in a wireless communication channel embodiment).

The LDPC encoder circuitry is operative to encode $d(1),...,d(K),z(K+1),...,z(T)$ using an LDPC code, LDPC(R), to get L-T parity/redundancy bits, shown as $p(1), ..., p(L-T)$.

With respect to OFDM, more than two separate and distinct puncturing patterns are employed. Instead three separate and distinct puncturing patterns are employed, depicted as punc[1], punc[2], and punc[3], respectively, on L-T parity bits, respectively, to get two three sub-sequences of un-punctured parity bits, say $p(set1) = \{p(i_1),p(i_2), ..., p(i_a)\}$, $p(set2) = \{p(j_1),p(j_2), ..., P(j_b)\}$, and $p(set2)=p(k_1), p(k_2), ..., p(k_c)$ such that $3 \times K+a+b+c=N$.

It is noted that punc[1] is a subset of $\{1,...,L-T\}$ of size L-T-a, punc[2] is a subset of $\{1,...,L-T\}$ of size L-T-b and punc[3] is a subset of $\{1,...,L-T\}$ of size L-T-c. The output duplicated information bits, e.g., $d(1), ..., d(K), d(1), ..., d(K)$, are followed by p(set1), p(set2) and p(set3). The effective code rate of such a header encoding approach is K/N.

While this embodiment shows an example of combining the bits to generate the header by employing the information bits, e.g., $d(1),...,d(K),d(1),...,d(K)$, are followed by p(set1) and p(set2), as described above, with respect to any embodiment of the SC PHY header and OFDM PHY header presented herein.

While this embodiment shows an example of combining the bits (e.g., using a spreading circuitry) to generate the header by employing the information bits, e.g., $d(1),...,d(K),d(1),...,d(K), d(1),...,d(K)$, are followed by p(set1), p(set2), and p(set3), as described above, with respect to any embodiment of the SC PHY header and OFDM PHY header presented herein. In an alternative embodiment, the header is generated by employing the information bits, e.g., $d(1),...,d(K)$ followed by p(set1), followed by a duplicate of the information bits, $d(1),...,d(K)$, and then followed by p(set2), followed by a duplicate of the information bits, $d(1),...,d(K)$, and then followed by p(set3).

It is again noted that any desired means of combination of the bits may be made to generate the final header (e.g., rearranging of the bits in accordance with scrambling, interleaving, etc. including switching the order of any two or more bits; the order in which the header information bits, the remaining/non-punctured bits [whether they be header information bits or parity/redundancy bits] may be emplaced in the final formed header in accordance with any desired manner or order as a particular embodiment or implementation would prefer or require. For example, while many of the embodiments presented herein, the header information bits (which are repeated) are followed by the parity/redundancy bits (which are also repeated). However, the order in which these bits are included to form the final header may also be changed without departing from the scope and spirit of the invention (e.g., parity/redundancy bits firstly followed by the header information bits; alternatively: header information bits followed by parity/redundancy bits then followed by a copy/duplicate of the header information bits then followed by a copy/duplicate of the parity/redundancy bits).

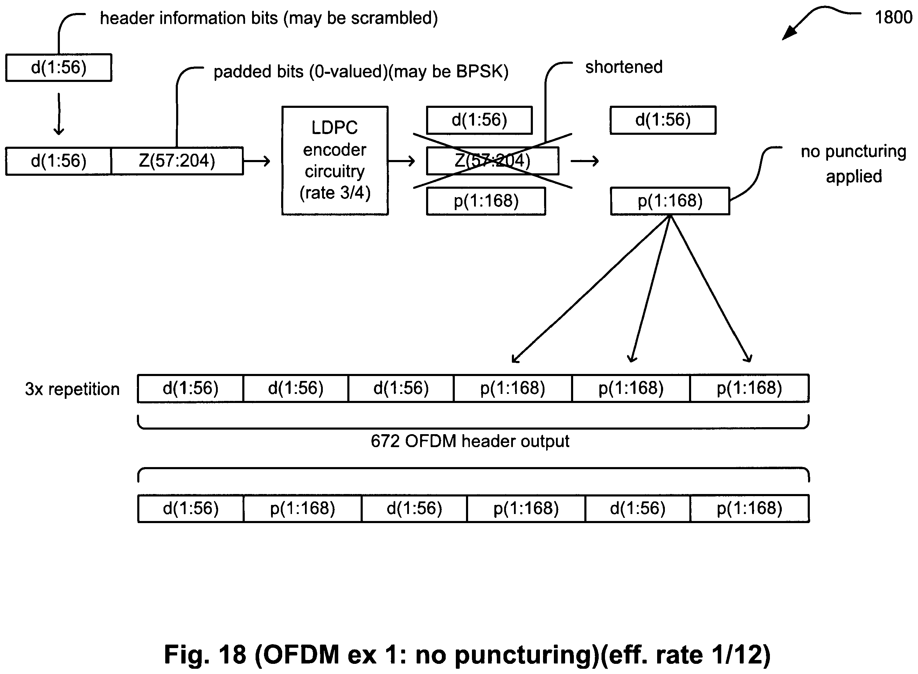

FIG. 18 illustrates an embodiment of an apparatus 1800 that is operative to process header information bits thereby generating a header in accordance with an effective coding rate of 1/12 for use in a PHY frame to be transmitted in accordance with OFDM signaling.

This embodiment employs no puncturing therein, and consequently no selective puncturing therein that applied different puncturing patterns to different portions of the block. This embodiment may be referred to as OFDM header encoding example 1 as having an effective rate 1/12, K=56, N=672, (672,504) LDPC code. Again, no puncturing is performed I this embodiment, i.e. punc[1]=punc[2] =punc[3]=Ø.

One embodiment forms the header (e.g., by using a spreader circuitry) by employing the information bits, e.g., d(1),...,d(56), d(1),...,d(56), d(1),...,d(56), followed by p(1),...,p(168), p(1),...,p(168), and p(1),...,p(168). However, in an alternative embodiment, the header is generated by employing the information bits, e.g., d(1),...,d(56) followed by p(1),...,p(168), then followed by a duplicate of the information bits, d(1),...,d(56), and then followed by p(1),...,p(168), and then followed by a duplicate of the information bits, d(1),...,d(56), and then followed by p(1),...,p(168). Again, any desired means of combination of the bits may be made to generate the final header.

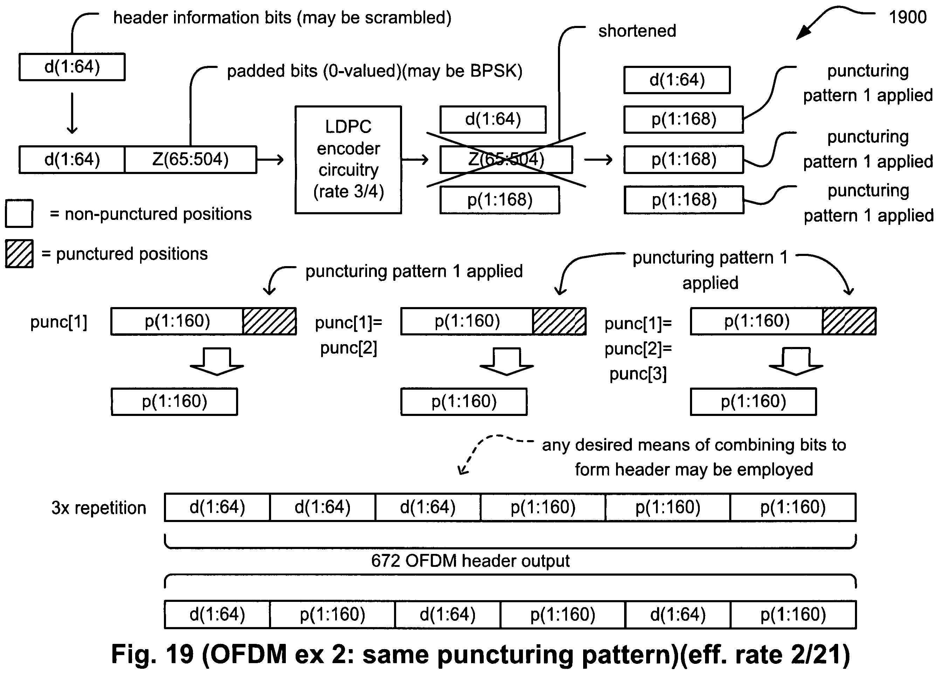

FIG. 19, FIG. 20 and FIG. 21 illustrate various embodiments of an apparatus 1900, 2000, and 2100, respectively, that is operative to process header information bits thereby generating a header, by employing selective puncturing, in accordance with an effective coding rate of 2/21 for use in a PHY frame to be transmitted in accordance with OFDM signaling.

Referring to embodiment 1900 of FIG. 19, a greater number of header information bits are employed than in certain previous embodiments (e.g., 64 header information bits vs. 56 header information bits). In addition, puncturing of selected bits is performed in this embodiment 1900. A common puncturing pattern is applied to different portions thereof.

This embodiment may be referred to as OFDM header encoding example 2 as having an effective rate 2/21, K=64, N=672, (672,504) LDPC code. As can be seen, a common puncturing pattern, depicted as punc[1] = punc[2] = punc[3]={161,162,...,168}, is applied to the parity/redundancy bits and the duplicate two separate copies generated there from.

In other embodiments, certain of the header information bits themselves may also undergo puncturing (as also presented below in other embodiments). Again, in this embodiment 1900 as well as in any embodiment presented herein, any desired means of combination of the bits may be made to generate the final header.

One embodiment forms the header (e.g., by using a spreader circuitry) by employing the information bits, e.g., d(1),...,d(64), d(1),...,d(64), and d(1),...,d(64), followed by p(1),...,p(160), p(1),...,p(160), and p(1),...,p(160). However, in an alternative embodiment, the header is generated by employing the information bits, e.g., d(1),...,d(64) followed by p(1),...,p(160), then followed by a duplicate of the information bits, d(1),...,d(64), and then followed by p(1),...,p(160), and then followed by a duplicate of the information bits, d(1),...,d(64), and then followed by p(1),...,p(160). Again, any desired means of combination of the bits may be made to generate the final header.

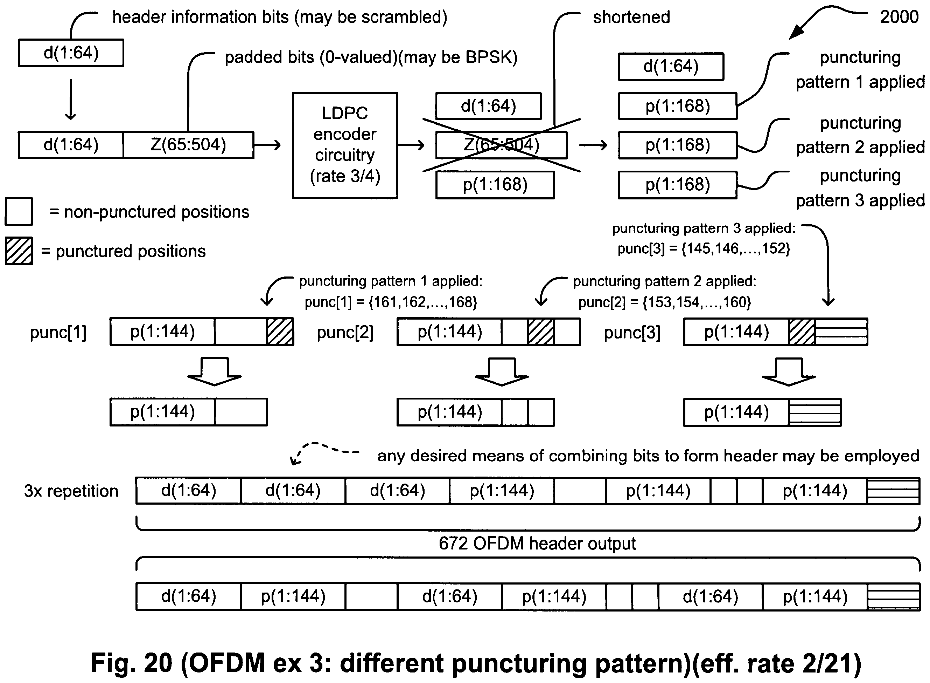

Referring to embodiment 2000 of FIG. 20, a greater number of header information bits are employed than in certain previous embodiments (e.g., 64 header information bits vs. 56 header information bits). In addition, puncturing of selected bits is performed in this embodiment 2000. At least two separate and distinct puncturing patterns are applied to different portions thereof.

This embodiment 1200 may be referred to as OFDM header encoding example 3 as having an effective rate 2/21, K=64, N=672, (672,504) LDPC code. As can be seen, three separate and distinct puncturing patterns, depicted as punc[1] = {161,162,...,168}, punc[2] = {153,154,...,160}, and punc[3] = {145,146,...,152}, respectively, are applied to the parity/redundancy bits and the duplicate copies generated there from. After puncturing, the remaining/non-punctured bits are composed of p(145:160), p(145:152) U p(161:168), p(153:168), respectively.

This embodiment 2000 shows the puncturing being performed therein to use consecutive puncturing. For example, a consecutive/ contiguous group of bits are punctured. Different consecutive/ contiguous portions of the parity/redundancy bits and the duplicate copies thereof undergo puncturing.

Again, in other embodiments, certain of the header information bits themselves may also undergo puncturing (as also presented below in other embodiments). Also, in this embodiment as well as in any embodiment presented herein, any desired means of combination of the bits may be made to generate the final header.

One embodiment forms the header (e.g., by using a spreader circuitry) by employing the information bits, e.g., d(1),...,d(64), d(1),...,d(64), and d(1),...,d(64), followed by p(1),...,p(144), followed by p(145:160), then followed by p(1),...,p(144), which is followed by p(145:152) U p(161:168), and then followed by p(1),...,p(144) which is followed by p(153:168). However, in an alternative embodiment, the header is generated by employing the information bits, e.g., d(1),...,d(64) followed by p(1),...,p(144), followed by p(145:160), then followed by a duplicate of the information bits, d(1),...,d(64), and then followed by p(1),...,p(144), which is followed by p(145:152) U p(161:168), and then followed by a duplicate of the information bits, p(1),...,p(144) which is followed by p(153:168). Again, any desired means of combination of the bits may be made to generate the final header.

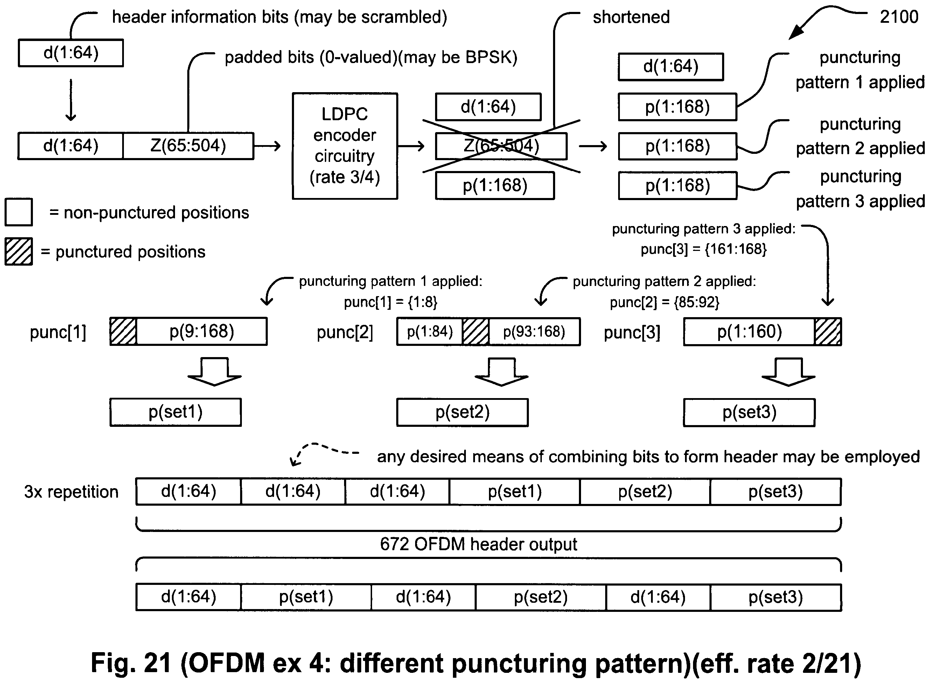

Referring to embodiment 2100 of FIG. 21, a greater number of header information bits are employed than in certain previous embodiments (e.g., 64 header information bits vs. 56 header information bits). In addition, puncturing of selected bits is performed in this embodiment 2100. At least three separate and distinct puncturing patterns are applied to different portions thereof.

This embodiment may be referred to as OFDM header encoding example 4 as having an effective rate 2/21, K=64, N=672, (672,504) LDPC code. As can be seen, three separate and distinct puncturing patterns, depicted as punc[1]= (1:8), punc[2]= (85:92), and punc[3]= (161:168), respectively, are applied to the parity/redundancy bits and the duplicate copies generated there from. After puncturing, the remaining/non-punctured bits are composed of p(set1)= p(9:168), p(set2)=p(1:84) U p(93:168), and p(set3)=p(1:160), respectively.

This embodiment 2100 shows the puncturing being performed therein to use consecutive puncturing. For example, a consecutive/ contiguous group of bits are punctured. Different consecutive/ contiguous portions of the parity/redundancy bits and the duplicate copies thereof undergo puncturing.

Again, in other embodiments, certain of the header information bits themselves may also undergo puncturing (as also presented below in other embodiments). Also, in this embodiment as well as in any embodiment presented herein, any desired means of combination of the bits may be made to generate the final header.

While this embodiment shows an example of combining the bits (e.g., using a spreading circuitry) to generate the header by employing the information bits, e.g., d(1),...,d(64),d(1),...,d(64), d(1),...,d(64), are followed by p(setl), p(set2), and p(set3), as described above, with respect to any embodiment of the SC PHY header and OFDM PHY header presented herein. In an alternative embodiment, the header is generated by employing the information bits, e.g., d(1),...,d(64) followed by p(set1), followed by a duplicate of the information bits, d(1),...,d(64), and then followed by p(set2), followed by a duplicate of the information bits, d(1),...,d(64), and then followed by p(set3).

In accordance with the header encoding presented herein, certain embodiments that perform header encoding (e.g., scrambled and encoded) using a single OFDM symbol may be described as follows:

(1) The 64 header bits ($b_1$, $b_2$, ..., $b_{LH}$), where LH = 64, are scrambled, starting from the eighth bit, to create $\mathbf{q}=(q_1,q_2,...,q_{LH})$

(2) The sequence q is padded with 440 zeros to obtain a total of 504 bits, $(q_1,q_2,...,q_{LH},0_{LH+1},0_{LH+2},...0_{504})$, which are then encoded using the rate-3/4 LDPC code. 168 parity bits, $p_1,p_2,...,p_{168}$, are generated.

(3) A sequence $\mathbf{c_1}$ is generated as $(q_1,q_2,...,q_{LH},p_9,p_{10},...p_{168})$.

(4) A sequence $\mathbf{c_2}$ is generated as $(q_1,q_2,...,q_{LH},p_1,p_2,...p_{84}, p_{93},p_{94},...p_{168})$ XORed with the one-time pad sequence (starting from left and with the LSB the first to be used in each nibble).

(5) A sequence $\mathbf{c_3}$ is generated as $(q_1,q_2...,q_{LH},p_1,p_2,...p_{160})$ XORed with the one-time pad sequence [which may be different than the one above] (starting from left and with the LSB the first to be used in each nibble).

(6) The sequences $\mathbf{c_1},\mathbf{c_2}$ and $\mathbf{c_3}$ are concatenated to form the 672-bit sequence $\mathbf{d}=(d_1,d_2,d_3,...,d_{672})=(\mathbf{c_1},\mathbf{c_2},\mathbf{c_3})$.

(7) The 672-bit sequence, $\mathbf{d}$, is then mapped as QPSK in accordance with a particular mapping of the constellation points therein, pilots (e.g., pilot symbols) are inserted and the resulting sequence is modulated as an OFDM symbol.

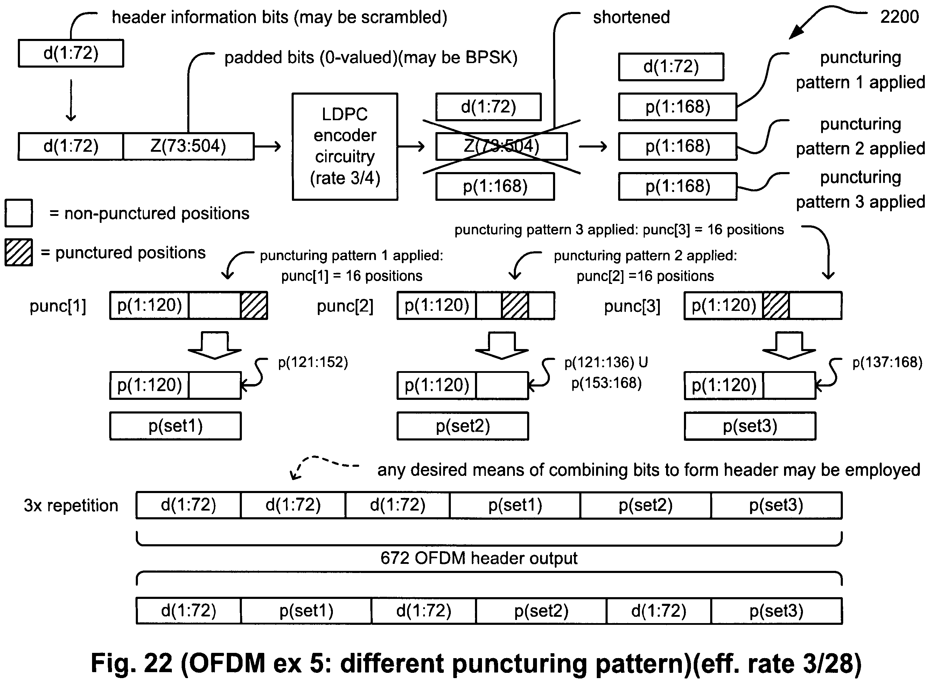

FIG. 22 illustrates an embodiment of an apparatus 2200 that is operative to process header information bits thereby generating a header, by employing selective puncturing, in accordance with an effective coding rate of 3/28 for use in a PHY frame to be transmitted in accordance with OFDM signaling.

Referring to embodiment 2200 of FIG. 22, an even greater number of header information bits are employed than in certain previous embodiments (e.g., 72 header information bits vs. 64 header information bits or 56 header information bits). In addition, puncturing of selected bits is performed in this embodiment 2200. At least three separate and distinct puncturing patterns are applied to different portions thereof.

This embodiment may be referred to as OFDM header encoding example 5 operating on an even greater number of header information bits (e.g., K=72) and as having an effective rate 3/28, K=72, N=672, (672,504) LDPC code. As can be seen, three separate and distinct puncturing patterns, each puncturing 16 positions, respectively, are applied to the parity/redundancy bits and the duplicate copies generated there from. After puncturing, the remaining/non-punctured bits are composed of p(121:152), p(121:136) U p(153:168), and p(137:168), respectively.

This embodiment 2200 shows the puncturing being performed therein to use consecutive puncturing. For example, a consecutive/ contiguous group of bits are punctured. Different consecutive/ contiguous portions of the parity/redundancy bits and the duplicate copies thereof undergo puncturing.

Again, in other embodiments, certain of the header information bits themselves may also undergo puncturing (as also presented below in other embodiments). Also, in this embodiment as well as in any embodiment presented herein, any desired means of combination of the bits may be made to generate the final header.

While this embodiment shows an example of combining the bits (e.g., using a spreading circuitry) to generate the header by employing the information bits, e.g., d(1),...,d(72),d(1),...,d(72), d(1),...,d(72), are followed by p(set1), p(set2), and p(set3), as described above, with respect to any embodiment of the SC PHY header and OFDM PHY header presented herein. In an alternative embodiment, the header is generated by employing the information bits, e.g., d(1),...,d(72) followed by p(set1), followed by a duplicate of the information bits, d(1),...,d(72), and then followed by p(set2), followed by a duplicate of the information bits, d(1),...,d(72), and then followed by p(set3).

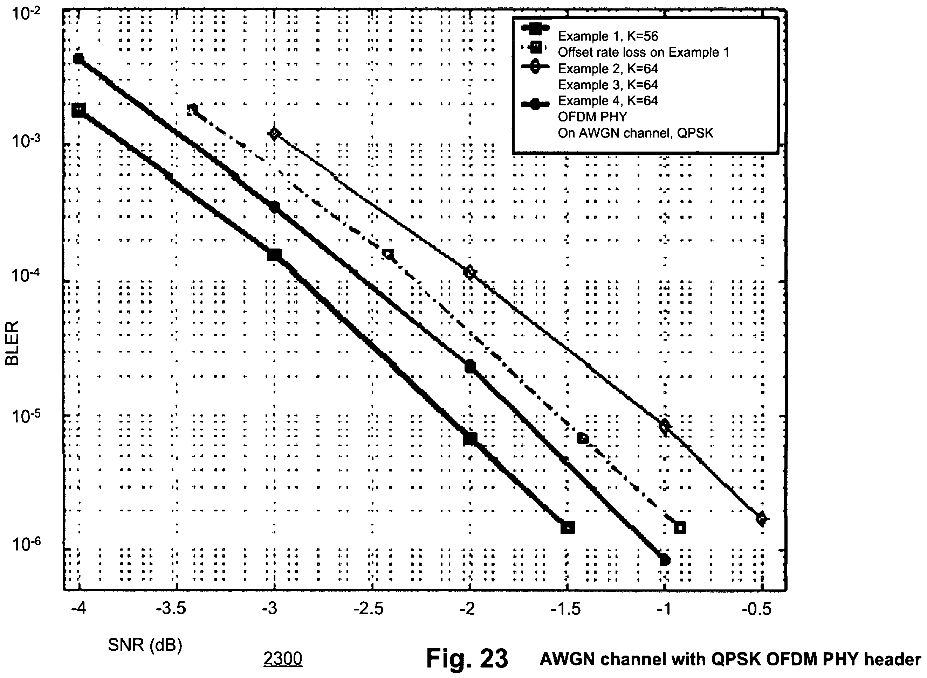

FIG. 23 illustrates an embodiment 2300 of performance comparisons of various LDPC codes, each employing a respective header encoding approach, using OFDM signaling with quadrature phase shift keying (QPSK) modulation on an AWGN communication channel.

The various examples 1, 2, 3, and 4 presented in certain of the previous diagrams are shown in this diagram to show the relative performance thereof based on a AWGN communication channel.

To compensate for the coding offset incurred by the different effective coding rate of 1/12 (corresponding to example 1) when compared to the effective coding rate of 2/21 (corresponding to examples 2, 3, and 4), the performance curve of example 1 is shifted appropriately to allow for an accurate comparison.

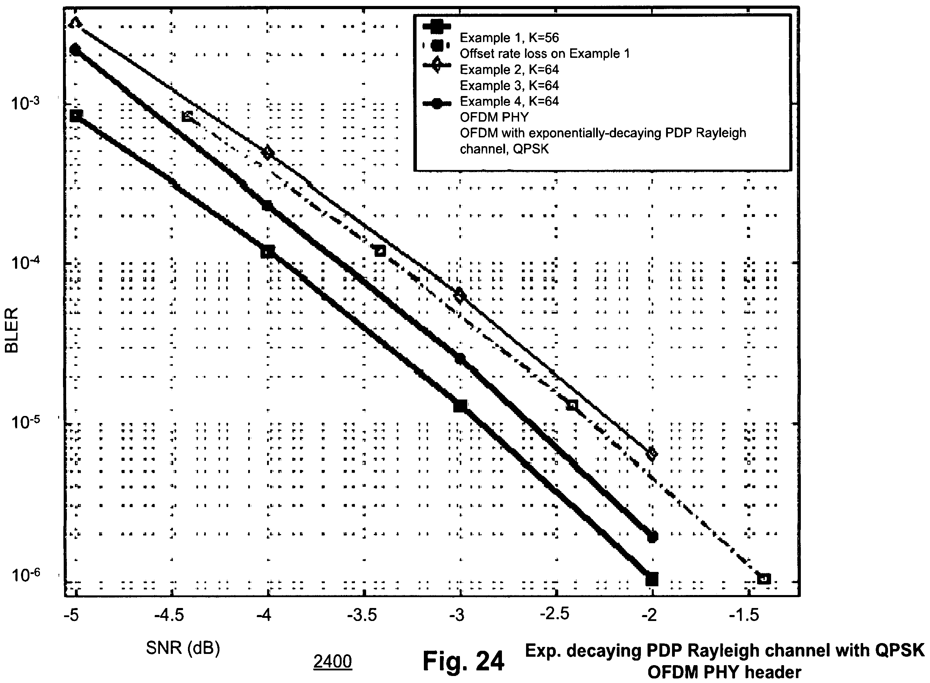

FIG. 24 illustrates an embodiment 2400 of performance comparisons of various LDPC codes, each employing a respective header encoding approach, using OFDM signaling with an exponential decaying PDP Rayleigh fading communication channel QPSK modulation.

Performance analysis for OFDM header

A net coding gain or loss may be incurred when considering rate loss of 1/12 comparing to 2/21. However, the net coding gain or loss of the effective rate 1/12 codes is of course should offset by approximately $10\log10((2/21)/(1/12))=0.58$ dB (e.g., see doted curves in the performance diagrams as referenced above).

In comparing to the effective rate 1/12 code (e.g., example 1) and the effective rate 2/21 codes (e.g., examples 2, 3, and 4) on an AWGN channel, the following observations may be made. Example 3 has no net performance loss. Example 4 has net 0.25 dB performance gain. An absolute (not counting rate gain) SNR loss of Example 4 is 0.25 dB.

In comparing to the effective rate 1/12 code (e.g., example 1) and the effective rate 2/21 codes (e.g., examples 2, 3, and 4) on OFDM with exponentially-decaying PDP Rayleigh channel, the following observations may be made. Example 3 has 0.12 dB net performance gain. Example 4 has net 0.25 dB performance gain. An absolute (not counting rate gain) SNR loss of Example 4 is 0.25 dB.

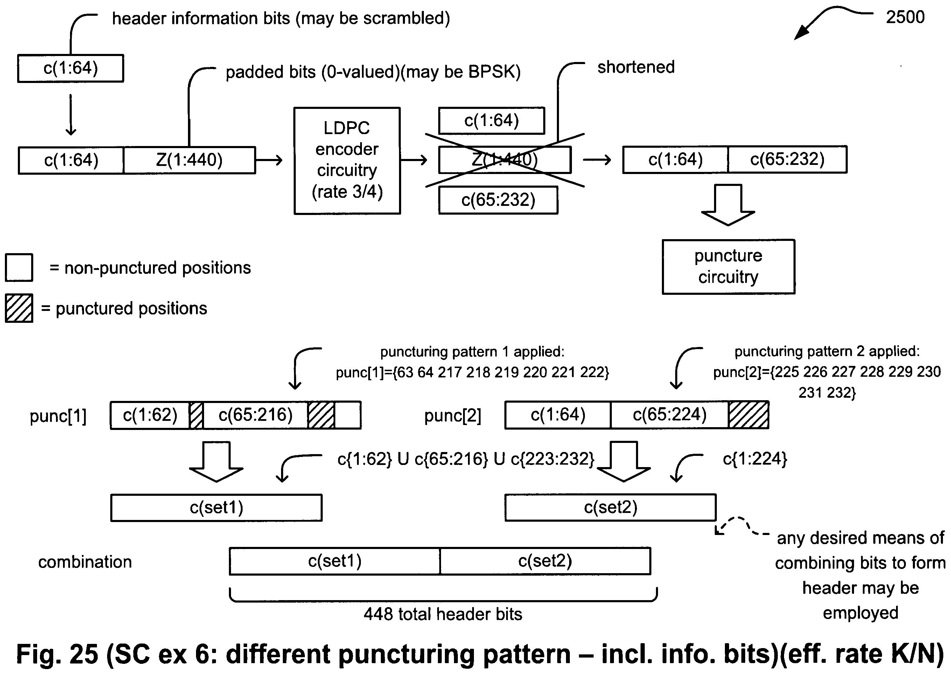

FIG. 25 illustrates an embodiment of 2500 an apparatus that is operative to process header information bits thereby generating a header, by employing selective puncturing including puncturing information bits in addition to parity/redundancy bits, in accordance with an effective coding rate of K/N (K and N integers) for use in a PHY frame to be transmitted in accordance with SC signaling.

A general header encoding (including selective puncturing of information bits)

These embodiments show how not only may parity/redundancy bits be selectively punctured, but the header information bits themselves (e.g., those bits that include the information that makes the frame self-describing) may be selectively punctured. As shown in other embodiments herein where two or more puncturing patterns may be applied to the parity/redundancy bits and any duplicate copies generate there from, similarly two or more puncturing patterns may be applied to the header information bits and any duplicate copies generate there from.

In accordance with SC signaling, certain operational parameters may be defined including: output size of the header encoding, say N; rate R (L,T) LDPC code, say LDPC(R), where L is the block size and T is the size of information bits.

The K header information bits (where $K \leq T$) may undergo scrambling thereby generating to get $c(1),...,c(K)$ that then undergo padding. After padding T-K 0 bits thereto (e.g., shown as $z(1),...,z(T-K)$ 0-valued bits that are padded after the K information bits (shortening)), then these K header information bits and the padded bits are provided to an LDPC encoder circuitry. Of course, it is noted that zero-valued bits (e.g., padded bits) are not transmitted via the communication channel (e.g., on the air in a wireless communication channel embodiment).

The LDPC encoder circuitry is operative to encode $c(1), ... , c(K), z(1), ... , z(T-K)$ using an LDPC code, LDPC(R), to get the output bits that includes parity/redundancy bits, shown as $c(1), c(2), ..., c(K), c(K+1), ..., c(K+L-T)$.

Thereafter, M separate and distinct puncturing patterns, depicted as punc[1], punc[2],..., punc[M], respectively, are applied on the K+L-T c bits, respectively, to get the following sub-sequences: $c(set1)=c(i_1),c(i_2),...,c(i_{a1})$; $c(set2)=c(j_1),c(j_2),...,c(j_{a2})$; ...; $c(setM)=c(k_1),c(k_2),...,c(k_{aM})$, respectively, such that $a1+a2+...+aM=N$.

The output sets of bits, $c(set1), c(set2),..., c(setM)$, are output in any preferred order. The effective code rate of such a header encoding approach is K/N.

This embodiment may be referred to as SC header encoding example 6 as having an effective rate 1/7, K=64, N=448, (672,504) LDPC code.

As can be seen, two separate and distinct puncturing patterns, punc[1] = {63 64 217 218 219 220 221 222}, and punc[2] = {225 226 227 228 229 230 231 232}, respectively, are applied to the various bits output from the LDPC encoder circuitry (including the header information bits output there from) and the duplicate copy generated there from.

After puncturing, the remaining/non-punctured bits are composed of c(setl)=c(1:62) U c(65:216) U c(223:232) and c(set2)=c(1:224), respectively.

This embodiment 2500 shows the puncturing being performed therein to use non-consecutive/non-contiguous puncturing. For example, a non-consecutive/non-contiguous group of bits are punctured. Different non-consecutive/non-contiguous portions of the various bits output from the LDPC encoder circuitry (including the header information bits output there from) and the duplicate copies thereof undergo puncturing.

In this embodiment, certain of the header information bits themselves have undergo puncturing. Also, in this embodiment as well as in any embodiment presented herein, any desired means of combination of the bits may be made to generate the final header.

While this embodiment shows an example of combining the bits to generate the header by employing the first set c(setl) followed by the c(set2), as described above, with respect to any embodiment of the SC PHY header and OFDM PHY header presented herein, it is again noted that any desired means of combination of the bits may be made to generate the final header (e.g., rearranging of the bits in accordance with scrambling, interleaving, etc. including switching the order of any two or more bits; the order in which the header information bits, the remaining/non-punctured bits [whether they be header information bits or parity/redundancy bits] may be emplaced in the final formed header in accordance with any desired manner or order as a particular embodiment or implementation would prefer or require. For example, while many of the embodiments presented herein, the header information bits (which are repeated) are followed by the parity/redundancy bits (which are also repeated). However, the order in which these bits are included to form the final header may also be changed without departing from the scope and spirit of the invention (e.g., parity/redundancy bits firstly followed by the header information bits; alternatively: header information bits followed by parity/redundancy bits then followed by a copy/duplicate of the header information bits then followed by a copy/duplicate of the parity/redundancy bits).

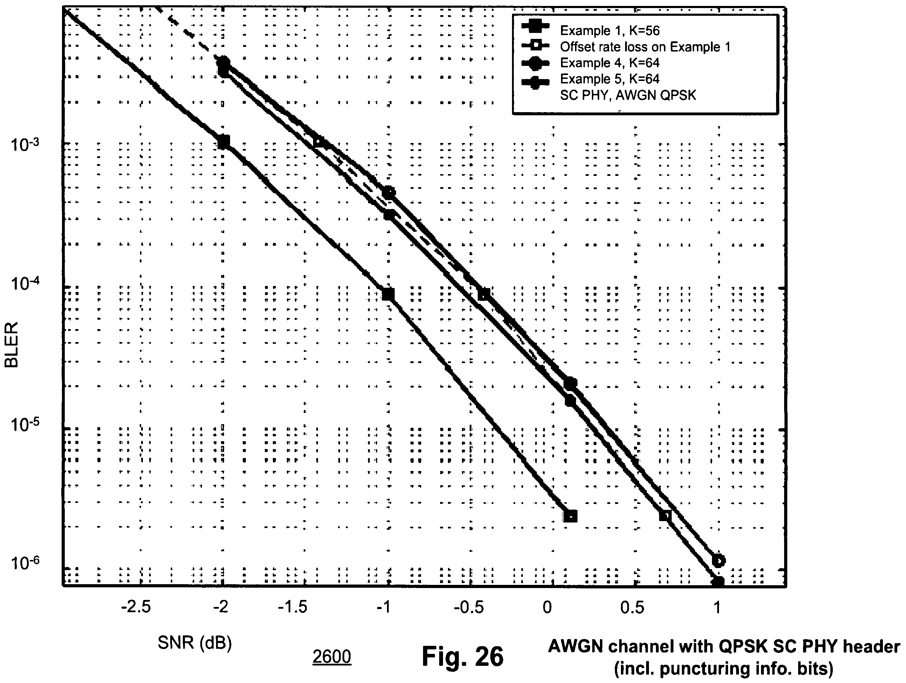

FIG. 26 illustrates an embodiment 2600 of performance comparisons of various LDPC codes, each employing a respective header encoding approach, using SC signaling with QPSK modulation on an AWGN communication channel.

The various examples 1, 4, and 5 presented in certain of the previous diagrams are shown in this diagram to show the relative performance thereof based on a AWGN communication channel.

To compensate for the coding offset incurred by the different effective coding rates, the performance curve of example 1 is shifted appropriately to allow for an accurate comparison.

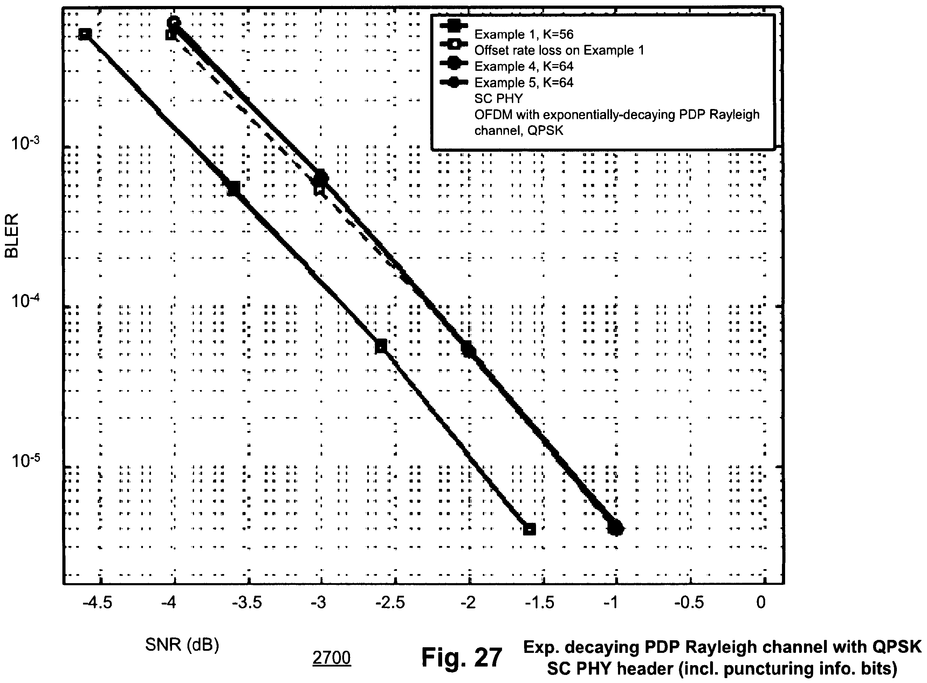

FIG. 27 illustrates an embodiment 2700 of performance comparisons of various LDPC codes, each employing a respective header encoding approach, using SC signaling with an exponential decaying PDP Rayleigh fading communication channel QPSK modulation.

The various examples 1, 4, and 5 presented in certain of the previous diagrams are shown in this diagram to show the relative performance thereof based on an exponential decaying PDP Rayleigh fading communication channel QPSK modulation.

Again, as with the previous embodiment 2600, to compensate for the coding offset incurred by the different effective coding rates, the performance curve of example 1 is shifted appropriately to allow for an accurate comparison.

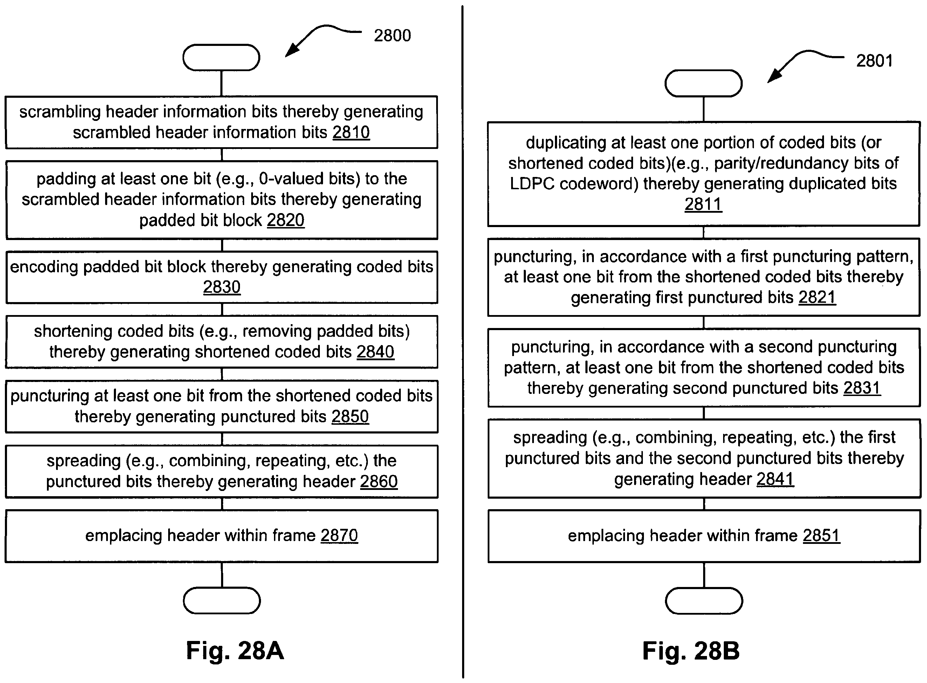

FIG. 28A illustrates an embodiment of a method 2800 for processing header information bits thereby generating a header.

Referring to method 2800 of FIG. 28A, the method 2800 begins by scrambling header information bits thereby generating scrambled header information bits, as shown in a block 2810. The method 2800 continues by padding at least one bit (e.g., 0-valued bits) to the scrambled header information bits thereby generating padded bit block, as shown in a block 2820.

The method 2800 then operates by encoding padded bit block thereby generating coded bits, as shown in a block 2830. The method 2800 continues by shortening coded bits (e.g., removing padded bits) thereby generating shortened coded bits, as shown in a block 2840. The method 2800 then operates by puncturing at least one bit from the shortened coded bits thereby generating punctured bits, as shown in a block 2850.

The method 2800 continues by spreading (e.g., combining, repeating, etc.) the punctured bits thereby generating header, as shown in a block 2860. The method 2800 then operates by emplacing header within frame, as shown in a block 2870.

FIG. 28B illustrates an embodiment of an alternatively method 2800 for processing header information bits thereby generating a header.

Referring to method 2801 of FIG. 28B, the method 2801 begins by duplicating at least one portion of coded bits (or shortened coded bits)(e.g., parity/redundancy bits of LDPC codeword) thereby generating duplicated bits, as shown in a block 2811. The method 2801 then operates by puncturing, in accordance with a first puncturing pattern, at least one bit from the shortened coded bits thereby generating first punctured bits, as shown in a block 2821.

The method 2801 continues by puncturing, in accordance with a second puncturing pattern, at least one bit from the shortened coded bits thereby generating second punctured bits, as shown in a block 2831. The method 2801 then operates by spreading (e.g., combining, repeating, etc.) the first punctured bits and the second punctured bits thereby generating header, as shown in a block 2841. The method 2800 then operates by emplacing header within frame, as shown in a block 2851.

It is noted that the various modules (e.g., encoding modules, decoding modules, header encoding modules, etc.) described herein may be a single processing device or a plurality of processing devices. Such a processing device may be a microprocessor, micro-controller, digital signal processor, microcomputer, central processing unit, field programmable gate array, programmable logic device, state machine, logic circuitry, analog circuitry, digital circuitry, and/or any device that manipulates signals (analog and/or digital) based on operational instructions. The operational instructions may be stored in a memory. The memory may be a single memory device or a plurality of memory devices. Such a memory device may be a read-only memory (ROM), random access memory (RAM), volatile memory, non-volatile memory, static memory, dynamic memory, flash memory, and/or any device that stores digital information. It is also noted that when the processing module implements one or more of its functions via a state machine, analog circuitry, digital circuitry, and/or logic circuitry, the memory storing the corresponding operational instructions is embedded with the circuitry comprising the state machine, analog circuitry, digital circuitry, and/or logic circuitry. In such an embodiment, a memory stores, and a processing module coupled thereto executes, operational instructions corresponding to at least some of the steps and/or functions illustrated and/or described herein.

The present invention has also been described above with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope of the claimed invention.

The present invention has been described above with the aid of functional building blocks illustrating the performance of certain significant functions. The boundaries of these functional building blocks have been arbitrarily defined for convenience of description. Alternate boundaries could be defined as long as the certain significant functions are appropriately performed. Similarly, flow diagram blocks may also have been arbitrarily defined herein to illustrate certain significant functionality. To the extent used, the flow diagram block boundaries and sequence could have been defined otherwise and still perform the certain significant functionality. Such alternate definitions of both functional building blocks and flow diagram blocks and sequences are thus within the scope of the claimed invention.

One of average skill in the art will also recognize that the functional building blocks, and other illustrative blocks, modules and components herein, can be implemented as illustrated or by discrete components, application specific integrated circuits, processors executing appropriate software and the like or any combination thereof.

Moreover, although described in detail for purposes of clarity and understanding by way of the aforementioned embodiments, the present invention is not limited to such embodiments. It will be obvious to one of average skill in the art that various changes and modifications may be practiced within the scope of the invention, as limited only by the scope of the appended claims.

**Claims**

1. An apparatus, comprising:

a padding circuitry that is operative to pad at least one bit to a plurality of header information bits thereby generating a padded bit block;
an LDPC (Low Density Parity Check) encoder circuitry, coupled to the padding circuitry, that is operative to encode the padded bit block thereby generating a plurality of LDPC coded bits;
a shorten/puncture circuitry, coupled to the encoder circuitry, that is operative to:

shorten at least one bit within the plurality of LDPC coded bits that corresponds to the at least one bit padded to the plurality of header information bits thereby generating a plurality of shortened coded bits;
perform repetition coding on the plurality of shortened coded bits thereby generating at least one duplicate of the plurality of shortened coded bits;
puncture at least one of the plurality of shortened coded bits thereby generating a first plurality of remaining bits; and

puncture at least one of the at least one duplicate of the plurality of shortened coded bits thereby generating a second plurality of remaining bits using a different puncturing pattern than for the at least one of the plurality of shortened coded bits; and

a spreader circuitry, coupled to the shorten/puncture circuitry, that is operative to process the first plurality of remaining bits and the second plurality of remaining bits thereby generating a header.

**2.** The apparatus of claim 1, further comprising:
a scrambler circuitry that is operative to scramble the plurality of header information bits before the plurality of header information bits is provided to the padding circuitry.

**3.** The apparatus of claim 1, wherein:
the header is emplaced into a signal that is launched from the apparatus into a communication channel using single carrier signaling.

**4.** The apparatus of claim 1, wherein the spreader circuitry is operative to generate the header by arranging:

the plurality of header information bits;
followed by a duplicate of plurality of header information bits;
followed by the first set of remaining bits; and
followed by the second set of remaining bits.

**5.** The apparatus of claim 1, wherein the spreader circuitry is operative to generate the header by arranging:

the plurality of header information bits;
followed by the first set of remaining bits;
followed by a duplicate of plurality of header information bits; and
followed by the second set of remaining bits.

**6.** The apparatus of claim 1, wherein:

the at least one duplicate of the plurality of shortened coded bits includes a first duplicate of the plurality of shortened coded bits and a second duplicate of the plurality of shortened coded bits; and
the shorten/puncture circuitry is operative to:

puncture at least one of the first duplicate of the plurality of shortened coded bits thereby generating the second plurality of remaining bits; and
puncture at least one of the second duplicate of the plurality of shortened coded bits thereby generating a third plurality of remaining bits using a different puncturing pattern than for the at least one of the first duplicate of the plurality of shortened coded bits; and
the spreader circuitry is operative to process the first plurality of remaining bits, the second plurality of remaining bits, and the third plurality of remaining bits thereby generating the header.

**7.** A method, comprising:

padding at least one bit to a plurality of header information bits thereby generating a padded bit block;
employing an LDPC (Low Density Parity Check) encoder circuitry to encode the padded bit block thereby generating a plurality of LDPC coded bits;
shortening at least one bit within the plurality of LDPC coded bits that corresponds to the at least one bit padded to the plurality of header information bits thereby generating a plurality of shortened coded bits;
performing repetition coding on the plurality of shortened coded bits thereby generating at least one duplicate of the plurality of shortened coded bits;
employing a first puncturing pattern to puncture at least one of the plurality of shortened coded bits thereby generating a first plurality of remaining bits; and
employing a second puncturing pattern to puncture at least one of the at least one duplicate of the plurality of shortened coded bits thereby generating a second plurality of remaining bits wherein the second puncturing pattern is different from the first puncturing pattern; and
processing the first plurality of remaining bits and the second plurality of remaining bits thereby generating a header.

8. The method of claim 7, further comprising:
scrambling the plurality of header information bits before padding the at least one bit to the plurality of header information bits.

9. The method of claim 7, further comprising:
emplacing into a signal that is launched into a communication channel using single carrier signaling.

10. The method of claim 7, wherein method further comprises generating the header by arranging:

the plurality of header information bits;
followed by a duplicate of plurality of header information bits;
followed by the first set of remaining bits; and
followed by the second set of remaining bits.

11. The method of claim 7, wherein the method further comprises generating the header by arranging:

the plurality of header information bits;
followed by the first set of remaining bits;
followed by a duplicate of plurality of header information bits; and
followed by the second set of remaining bits.

12. The method of claim 7, wherein the at least one duplicate of the plurality of shortened coded bits includes a first duplicate of the plurality of shortened coded bits and a second duplicate of the plurality of shortened coded bits; and the shorten/puncture circuitry is operative to:

puncture at least one of the first duplicate of the plurality of shortened coded bits thereby generating the second plurality of remaining bits; and
puncture at least one of the second duplicate of the plurality of shortened coded bits thereby generating a third plurality of remaining bits using a different puncturing pattern than for the at least one of the first duplicate of the plurality of shortened coded bits; and

the spreader circuitry is operative to process the first plurality of remaining bits, the second plurality of remaining bits, and the third plurality of remaining bits thereby generating the header.

13. The method of claim 7, wherein the method further comprises:
emplacing into a signal that is launched into a communication channel using orthogonal frequency division multiplexing (OFDM) signaling.

14. The method of claim 12, wherein the method further comprises generating the header by arranging:

the plurality of header information bits;
followed by a first duplicate of plurality of header information bits;
followed by a second duplicate of plurality of header information bits;
followed by the first set of remaining bits;
followed by the second set of remaining bits; and
followed by the third set of remaining bits.

15. The method of claim 12, wherein the method further comprises generating the header by arranging:

the plurality of header information bits;
followed by the first set of remaining bits;
followed by a first duplicate of plurality of header information bits;
followed by the second set of remaining bits;
followed by a second duplicate of plurality of header information bits; and
followed by the third set of remaining bits.

**Patentansprüche**

1. Vorrichtung, die aufweist:

   eine Auffüllschaltung bzw. Padding Circuitry, die dazu betreibbar ist, eine Vielzahl von Headerinformationsbits mit wenigstens einem Bit aufzufüllen, um dadurch einen aufgefüllten Bitblock zu erzeugen;
   eine LDPC (Low Density Parity Check) -Codierschaltung, die mit der Auffüllschaltung verbunden und dazu betreibbar ist, den aufgefüllten Bitblock zu codieren, um dadurch eine Vielzahl LDPC-codierter Bits zu erzeugen;
   eine Verkürzungs-/Durchlöcherungsschaltung, die mit der Codierschaltung verbunden und betreibbar ist zum:

   Verkürzen wenigstens eines Bits in der Vielzahl LDPC-codierter Bits, das dem wenigstens einen Bit entspricht, mit dem die Vielzahl von Headerinformationsbits aufgefüllt wurde, um dadurch eine Vielzahl verkürzter codierter Bits zu erzeugen;
   Durchführen von Wiederholungscodierung für die Vielzahl verkürzter codierter Bits, um dadurch wenigstens ein Duplikat der Vielzahl verkürzter codierter Bits zu erzeugen;
   Durchlöchern wenigstens eines der Vielzahl verkürzter codierter Bits, um dadurch eine erste Vielzahl verbleibender Bits zu erzeugen; und
   Durchlöchern wenigstens eines des wenigstens einen Duplikats der Vielzahl verkürzter codierter Bits, um dadurch eine zweite Vielzahl verbleibender Bits zu erzeugen, unter Verwendung eines anderen Durchlöcherungsmusters als für das wenigstens eine der Vielzahl verkürzter codierter Bits; und

   eine Spreizschaltung, die mit der Verkürzungs-/Durchlöcherungsschaltung verbunden und dazu betreibbar ist, die erste Vielzahl verbleibender Bits und die zweite Vielzahl verbleibender Bits zu verarbeiten und dadurch einen Header zu erzeugen.

2. Vorrichtung nach Anspruch 1, die des Weiteren aufweist:
   eine Scrambler- bzw. Verwürflerschaltung, die dazu betreibbar ist, die Vielzahl von Headerinformationsbits zu verwürfeln, bevor die Vielzahl von Headerinformationsbits an die Auffüllschaltung geliefert wird.

3. Vorrichtung nach Anspruch 1, wobei:
   der Header in ein Signal eingelagert wird, das von der Vorrichtung unter Verwendung von Einzelträgersignalisierung in einen Kommunikationskanal eingeführt wird.

4. Vorrichtung nach Anspruch 1, wobei die Spreizschaltung dazu betreibbar ist, den Header zu erzeugen durch Anordnen:

   der Vielzahl von Headerinformationsbits;
   gefolgt von einem Duplikat der Vielzahl von Headerinformationsbits;
   gefolgt von dem ersten Satz verbleibender Bits; und
   gefolgt von dem zweiten Satz verbleibender Bits.

5. Vorrichtung nach Anspruch 1, wobei die Spreizschaltung dazu betreibbar ist, den Header zu erzeugen durch Anordnen:

   der Vielzahl von Headerinformationsbits;
   gefolgt von dem ersten Satz verbleibender Bits;
   gefolgt von einem Duplikat der Vielzahl von Headerinformationsbits; und
   gefolgt von dem zweiten Satz verbleibender Bits.

6. Vorrichtung nach Anspruch 1, wobei:

   das wenigstens eine Duplikat der Vielzahl verkürzter codierter Bits ein erstes Duplikat der Vielzahl verkürzter codierter Bits und ein zweite Duplikat der Vielzahl verkürzter codierter Bits aufweist; und
   die Verkürzungs-/Durchlöcherungsschaltung betreibbar ist zum:

   Durchlöchern wenigstens eines des ersten Duplikats der Vielzahl verkürzter Bits, um dadurch die zweite Vielzahl verbleibender Bits zu erzeugen; und
   Durchlöchern wenigstens eines des zweiten Duplikats der Vielzahl verkürzter codierter Bits, um dadurch eine dritte Vielzahl verbleibender Bits zu erzeugen, unter Verwendung eines anderen Durchlöcherungsmusters als für das wenigstens eine des ersten Duplikats der Vielzahl verkürzter codierter Bits; und

die Spreizschaltung dazu betreibbar ist, die erste Vielzahl verbleibender Bits, die zweite Vielzahl verbleibender Bits und die dritte Vielzahl verbleibender Bits zu verarbeiten, um dadurch den Header zu erzeugen.

7. Verfahren, das umfasst:

Auffüllen einer Vielzahl von Headerinformationsbits mit wenigstens einem Bit, um dadurch einen aufgefüllten Bitblock zu erzeugen;
Verwenden einer LDPC (Low Density Parity Check) -Codierschaltung, um den aufgefüllten Bitblock zu codieren, um dadurch eine Vielzahl LDPC-codierter Bits zu erzeugen;
Verkürzen wenigstens eines Bits in der Vielzahl LDPC-codierter Bits, das dem wenigstens einen Bit entspricht, mit dem die Vielzahl von Headerinformationsbits aufgefüllt wurde, um dadurch eine Vielzahl verkürzter codierter Bits zu erzeugen;
Durchführen von Wiederholungscodierung für die Vielzahl verkürzter codierter Bits, um dadurch wenigstens ein Duplikat der Vielzahl verkürzter codierter Bits zu erzeugen;
Verwenden eines ersten Durchlöcherungsmusters, um wenigstens eines der Vielzahl verkürzter codierter Bits zu durchlöchern, um dadurch eine erste Vielzahl verbleibender Bits zu erzeugen; und
Verwenden eines zweiten Durchlöcherungsmusters, um wenigstens eines des wenigstens einen Duplikats der Vielzahl verkürzter codierter Bits zu durchlöchern, um dadurch eine zweite Vielzahl verbleibender Bits zu erzeugen, wobei sich das zweite Durchlöcherungsmuster von dem ersten Durchlöcherungsmuster unterscheidet; und
Verarbeiten der ersten Vielzahl verbleibender Bits und der zweiten Vielzahl verbleibender Bits, um dadurch einen Header zu erzeugen.

8. Verfahren nach Anspruch 7, das des Weiteren umfasst:
Verwürfein der Vielzahl von Headerinformationsbits zu verwürfeln, bevor die Vielzahl von Headerinformationsbits mit dem wenigstens einen Bit aufgefüllt wird.

9. Verfahren nach Anspruch 7, das des Weiteren umfasst:
Einlagern in ein Signal, das in einen Kommunikationskanal eingeführt wird, unter Verwendung von Einzelträgersignalisierung.

10. Verfahren nach Anspruch 7, wobei das Verfahren des Weiteren das Erzeugen des Headers umfasst durch Anordnen:

der Vielzahl von Headerinformationsbits;
gefolgt von einem Duplikat der Vielzahl von Headerinformationsbits;
gefolgt von dem ersten Satz verbleibender Bits; und
gefolgt von dem zweiten Satz verbleibender Bits.

11. Verfahren nach Anspruch 7, wobei das Verfahren des Weiteren das Erzeugen des Headers umfasst durch Anordnen:

der Vielzahl von Headerinformationsbits;
gefolgt von dem ersten Satz verbleibender Bits;
gefolgt von einem Duplikat der Vielzahl von Headerinformationsbits; und
gefolgt von dem zweiten Satz verbleibender Bits.

12. Verfahren nach Anspruch 7, wobei das wenigstens eine Duplikat der Vielzahl verkürzter codierter Bits ein erstes Duplikat der Vielzahl verkürzter codierter Bits und ein zweites Duplikat der Vielzahl verkürzter codierter Bits aufweist; und
die Verkürzungs-/Durchlöcherungsschaltung betreibbar ist zum:

Durchlöchern wenigstens eines des ersten Duplikats der Vielzahl verkürzter Bits, um dadurch die zweite Vielzahl verbleibender Bits zu erzeugen; und
Durchlöchern wenigstens eines des zweiten Duplikats der Vielzahl verkürzter codierter Bits, um dadurch eine dritte Vielzahl verbleibender Bits zu erzeugen, unter Verwendung eines anderen Durchlöcherungsmusters als für das wenigstens eine des ersten Duplikats der Vielzahl verkürzter codierter Bits; und

die Spreizschaltung dazu betreibbar ist, die erste Vielzahl verbleibender Bits, die zweite Vielzahl verbleibender Bits und die dritte Vielzahl verbleibender Bits zu verarbeiten, um dadurch den Header zu erzeugen.

13. Verfahren nach Anspruch 7, wobei das Verfahren des Weiteren umfasst: Einlagern in ein Signal, das in einen Kommunikationskanal eingeführt wird, unter Verwendung von orthogonalem Frequenzmultiplexverfahren- bzw. Orthogonal Frequency Division Multiplexing (OFDM) - Signalisierung.

14. Verfahren nach Anspruch 12, wobei das Verfahren des Weiteren das Erzeugen des Headers umfasst durch Anordnen:

    der Vielzahl von Headerinformationsbits;
    gefolgt von einem ersten Duplikat der Vielzahl von Headerinformationsbits;
    gefolgt von einem zweiten Duplikat der Vielzahl von Headerinformationsbits;
    gefolgt von dem ersten Satz verbleibender Bits;
    gefolgt von dem zweiten Satz verbleibender Bits; und
    gefolgt von dem dritten Satz verbleibender Bits.

15. Verfahren nach Anspruch 12, wobei das Verfahren des Weiteren das Erzeugen des Headers umfasst durch Anordnen:

    der Vielzahl von Headerinformationsbits;
    gefolgt von dem ersten Satz verbleibender Bits;
    gefolgt von einem ersten Duplikat der Vielzahl von Headerinformationsbits;
    gefolgt von dem zweiten Satz verbleibender Bits;
    gefolgt von einem zweiten Duplikat der Vielzahl von Headerinformationsbits; und
    gefolgt von dem dritten Satz verbleibender Bits.

## Revendications

1. Appareil, comprenant :

    un ensemble de circuits de remplissage qui est utilisable pour remplir au moins un bit dans une pluralité de bits d'information d'en-tête, générant ainsi un bloc de bits rempli ;
    un ensemble de circuits d'encodeur LDPC (contrôle de parité basse densité), couplé à l'ensemble de circuits de remplissage, qui est utilisable pour encoder le bloc de bits rempli, générant ainsi une pluralité de bits codés LDPC ;
    un ensemble de circuits de réduction/perforation, couplé à l'ensemble de circuits d'encodeur, qui est utilisable pour :

        réduire au moins un bit au sein de la pluralité de bits codés LDPC qui correspond à l'au moins un bit rempli dans la pluralité de bits d'information d'en-tête, générant ainsi une pluralité de bits codés réduits ;
        exécuter un codage par répétition sur la pluralité de bits codés réduits, générant ainsi au moins un duplicata de la pluralité de bits codés réduits ;
        perforer au moins un de la pluralité de bits codés réduits, générant ainsi une première pluralité de bits restants ; et
        perforer au moins un de l'au moins un duplicata de la pluralité de bits codés réduits, générant ainsi une deuxième pluralité de bits restants en utilisant un profil de perforation différent de celui pour l'au moins un de la pluralité de bits codés réduits ; et

    un ensemble de circuits d'étalement, couplé à l'ensemble de circuits de réduction/perforation, qui est utilisable pour traiter la première pluralité de bits restants et la deuxième pluralité de bits restants, générant ainsi un en-tête.

2. Appareil selon la revendication 1, comprenant en outre :
un ensemble de circuits d'embrouilleur qui est utilisable pour embrouiller la pluralité de bits d'information d'en-tête avant que la pluralité de bits d'information d'en-tête ne soit fournie à l'ensemble de circuits de remplissage.

3. Appareil selon la revendication 1, dans lequel :

l'en-tête est mis en place dans un signal qui est lancé de l'appareil jusque dans un canal de communication en utilisant une signalisation à porteuse unique.

4. Appareil selon la revendication 1, dans lequel l'ensemble de circuits d'étalement est utilisable pour générer l'en-tête en agençant :

la pluralité de bits d'information d'en-tête ;
suivie d'un duplicata de la pluralité de bits d'information d'en-tête ;
suivi du premier ensemble de bits restants ; et
suivi du deuxième ensemble de bits restants.

5. Appareil selon la revendication 1, dans lequel l'ensemble de circuits d'étalement est utilisable pour générer l'en-tête en agençant :

la pluralité de bits d'information d'en-tête ;
suivie du premier ensemble de bits restants ;
suivi d'un duplicata de la pluralité de bits d'information d'en-tête ; et
suivi du deuxième ensemble de bits restants.

6. Appareil selon la revendication 1, dans lequel :

l'au moins un duplicata de la pluralité de bits codés réduits inclut un premier duplicata de la pluralité de bits codés réduits et un deuxième duplicata de la pluralité de bits codés réduits ; et
l'ensemble de circuits de réduction/perforation est utilisable pour :

perforer au moins un du premier duplicata de la pluralité de bits codés réduits, générant ainsi la deuxième pluralité de bits restants ; et
perforer au moins un du deuxième duplicata de la pluralité de bits codés réduits, générant ainsi une troisième pluralité de bits restants en utilisant un profil de perforation différent de celui pour l'au moins un du premier duplicata de la pluralité de bits codés réduits ; et

l'ensemble de circuits d'étalement est utilisable pour traiter la première pluralité de bits restants, la deuxième pluralité de bits restants, et la troisième pluralité de bits restants, générant ainsi l'en-tête.

7. Procédé, comprenant :

le remplissage d'au moins un bit dans une pluralité de bits d'information d'en-tête, générant ainsi un bloc de bits rempli ;
l'emploi d'un ensemble de circuits d'encodeur LDPC (contrôle de parité basse densité) pour encoder le bloc de bits rempli, générant ainsi une pluralité de bits codés LDPC ;
la réduction d'au moins un bit au sein de la pluralité de bits codés LDPC qui correspond à l'au moins un bit rempli dans la pluralité de bits d'information d'en-tête, générant ainsi une pluralité de bits codés réduits ;
l'exécution d'un codage par répétition sur la pluralité de bits codés réduits, générant ainsi au moins un duplicata de la pluralité de bits codés réduits ;
l'emploi d'un premier profil de perforation pour perforer au moins un de la pluralité de bits codés réduits, générant ainsi une première pluralité de bits restants ; et
l'emploi d'un deuxième profil de perforation pour perforer au moins un de l'au moins un duplicata de la pluralité de bits codés réduits, générant ainsi une deuxième pluralité de bits restants dans lequel le deuxième profil de perforation est différent du premier profil de perforation ; et
le traitement de la première pluralité de bits restants et de la deuxième pluralité de bits restants, générant ainsi un en-tête.

8. Procédé selon la revendication 7, comprenant en outre :
l'embrouillage de la pluralité de bits d'information d'en-tête avant le remplissage de l'au moins un bit dans la pluralité de bits d'information d'en-tête.

9. Procédé selon la revendication 7, comprenant en outre :
la mise en place dans un signal qui est lancé jusque dans un canal de communication en utilisant une signalisation à porteuse unique.

**10.** Procédé selon la revendication 7, dans lequel le procédé comprend en outre la génération de l'en-tête en agençant :

 la pluralité de bits d'information d'en-tête ;
 suivie d'un duplicata de la pluralité de bits d'information d'en-tête ;
 suivi du premier ensemble de bits restants ; et
 suivi du deuxième ensemble de bits restants.

**11.** Procédé selon la revendication 7, dans lequel le procédé comprend en outre la génération de l'en-tête en agençant :

 la pluralité de bits d'information d'en-tête ;
 suivie du premier ensemble de bits restants ;
 suivi d'un duplicata de la pluralité de bits d'information d'en-tête ; et
 suivi du deuxième ensemble de bits restants.

**12.** Procédé selon la revendication 7, dans lequel l'au moins un duplicata de la pluralité de bits codés réduits inclut un premier duplicata de la pluralité de bits codés réduits et un deuxième duplicata de la pluralité de bits codés réduits ; et l'ensemble de circuits de réduction/perforation est utilisable pour :

 perforer au moins un du premier duplicata de la pluralité de bits codés réduits, générant ainsi la deuxième pluralité de bits restants ; et
 perforer au moins un du deuxième duplicata de la pluralité de bits codés réduits, générant ainsi une troisième pluralité de bits restants en utilisant un profil de perforation différent de celui pour l'au moins un du premier duplicata de la pluralité de bits codés réduits ; et

l'ensemble de circuits d'étalement est utilisable pour traiter la première pluralité de bits restants, la deuxième pluralité de bits restants, et la troisième pluralité de bits restants, générant ainsi l'en-tête.

**13.** Procédé selon la revendication 7, dans lequel le procédé comprend en outre :
la mise en place dans un signal qui est lancé jusque dans un canal de communication en utilisant une signalisation par multiplexage par répartition orthogonale de la fréquence (OFDM).

**14.** Procédé selon la revendication 12, dans lequel le procédé comprend en outre la génération de l'en-tête en agençant :

 la pluralité de bits d'information d'en-tête ;
 suivie d'un premier duplicata de la pluralité de bits d'information d'en-tête ;
 suivi d'un deuxième duplicata de la pluralité de bits d'information d'en-tête ;
 suivi du premier ensemble de bits restants ;
 suivi du deuxième ensemble de bits restants ; et
 suivi du troisième ensemble de bits restants.

**15.** Procédé selon la revendication 12, dans lequel le procédé comprend en outre la génération de l'en-tête en agençant :

 la pluralité de bits d'information d'en-tête;
 suivie du premier ensemble de bits restants ;
 suivi d'un premier duplicata de la pluralité de bits d'information d'en-tête ;
 suivi du deuxième ensemble de bits restants ;
 suivi d'un deuxième duplicata de la pluralité de bits d'information d'en-tête ; et
 suivi du troisième ensemble de bits restants.

**Fig. 1**

Fig. 2

EP 2 320 574 B1

variable nodes (or bit nodes) 310

check nodes 320

300

$d_c$ 324

$d_v$ 314

$v_i$ 312

edge 330

$c_j$ 322

**Fig. 3**

EP 2 320 574 B1

Fig. 4B (check node update)

Fig. 4A (variable node update)

500

header includes information corresponding to payload (e.g., frame length, code type, code rate, modulation [symbol mapping/constellation], etc.)

| preamble | header | data (alt., payload) |
|---|---|---|

frame

| header information bits (to be encoded for header) | ⇒ | header encoding | ⇒ | header |
|---|---|---|---|---|

make frame self-describing

**Fig. 5**

EP 2 320 574 B1

EP 2 320 574 B1

600

header information bits

LDPC

header

scrambler circuitry 610

padding circuitry 620

encoder circuitry 630

shorten and/or puncture circuitry 640

spreader (repeater) circuitry 650

**Fig. 6**

header information bits

700

padded bits (0-valued)(may be BPSK)

d0(1:56)

| d0(1:56) | Z(1:448) |

LDPC encoder
circuitry
(672,504),
R=3/4

d0(1:56)

Z(1:448)

p0(1:168)

parity/redundancy bits

| d0(1:56) | p0(1:168) |

repeating/
spreading

| sd0(1:112) | sp0(1:336) |

448 total header bits

**Fig. 7  (SC header encoding)(eff. rate 1/8)**

(scrambled) header information bits
(56 bits)

$b_1$ | $b_2$ | $b_3$ | O O O | $b_{56}$

800

(scrambled) header information bits
(56 bits)

parity/redundancy bits (168 bits)

shortened LDPC codeword (224 bits)

$c_1$ | $c_2$ | $c_3$ | O O O | $c_{56}$ | $c_{57}$ | $c_{58}$ | $c_{59}$ | O O O | $c_{224}$

repeating/
spreading 3x

shortened LDPC codeword (224 bits)    shortened LDPC codeword (224 bits)    shortened LDPC codeword (224 bits)

3x repetition of shortened codeword LDPC codeword (672 bits)

$c_1$ | O O O | $c_{56}$ | $c_{57}$ | O O O | $c_{224}$ | $c_1$ | O O O | $c_{224}$ | $c_1$ | O O O | $c_{56}$ | $c_{57}$ | O O O | $c_{224}$

QPSK mapping, pilot insertion,
and OFDM encoding

OFDM symbol

**Fig. 8  (OFDM header encoding)(eff. rate 1/12)**

EP 2 320 574 B1

header information bits (may be scrambled)

d(1:K)

padded bits (0-valued)(may be BPSK)

shortened

d(1:K)

d(1:K)        Z(K+1:L)        →

LDPC
encoder
circuitry

→

d(1:K)

~~Z(K+1:L)~~

Z(L+1:T)

→

d(1:K)

Z(L+1:T)

Z(L+1:T)

puncturing
pattern 1 applied

puncturing
pattern 2 applied

☐ = non-punctured positions

▨ = punctured positions

L-T parity/redundancy bits

puncturing pattern 1 applied

puncturing pattern 2 applied

Z(L+1:T)

Z(L+1:T)

⇓

⇓

p(set1)

p(set2)

| d(1:K) | d(1:K) | p(set1) | p(set2) |

total header bits

| d(1:K) | p(set1) | d(1:K) | p(set2) |

## Fig. 9 (SC header encoding)(eff. rate K/N)

EP 2 320 574 B1

header information bits (may be scrambled)

d(1:56)

padded bits (0-valued)(may be BPSK)

shortened

| d(1:56) | Z(57:204) |

→

LDPC
encoder
circuitry
(rate 3/4)

→

d(1:56)

~~Z(57:204)~~

p(1:168)

→

d(1:56)

p(1:168)

no puncturing
applied

| d(1:56) | d(1:56) | p(1:168) | p(1:168) |

448 total header bits

| d(1:56) | p(1:168) | d(1:56) | p(1:168) |

**Fig. 10 (SC ex 1: no puncturing)(eff. rate 1/8)**

1000

EP 2 320 574 B1

header information bits (may be scrambled)

d(1:64)

padded bits (0-valued)(may be BPSK)

shortened

d(1:64)    Z(65:504)    →    LDPC
                              encoder
                              circuitry
                              (rate 3/4)    →

d(1:64)

Z(65:504)

p(1:168)

d(1:64)

p(1:168)

p(1:168)

puncturing pattern 1 applied

puncturing pattern 1 applied

▨ = punctured positions

puncturing pattern 1 applied

puncturing pattern 1 applied

punc[1]    p(1:160)    ▨

⇓

p(1:160)

punc[1]=
punc[2]    p(1:160)    ▨

⇓

p(1:160)

any desired means of
combining bits to form
header may be
employed

2x repetition    | d(1:64) | d(1:64) | p(1:160) | p(1:160) |

448 total header bits

| d(1:64) | p(1:160) | d(1:64) | p(1:160) |

Fig. 11 (SC ex 2: same puncturing pattern)(eff. rate 1/7)

EP 2 320 574 B1

header information bits (may be scrambled)

d(1:64)

padded bits (0-valued)(may be BPSK)    shortened

d(1:64)    Z(65:504)  →  LDPC
encoder
circuitry
(rate 3/4)  →  d(1:64)

Z(65:504)

p(1:168)  →  d(1:64)

p(1:168)  puncturing
pattern 1 applied

p(1:168)  puncturing
pattern 2 applied

□ = non-punctured positions

▨ = punctured positions

puncturing pattern 1 applied:
punc[1]={161,162,...,168}

puncturing pattern 2 applied:
punc[2]={153,154,...,160}

punc[1]   p(1:152)   ▨     punc[2]   p(1:152)  ▨

p(153:160)    p(161:168)

p(1:152)    p(1:152)

any desired means of
combining bits to form
header may be
employed

2x repetition   d(1:64)  d(1:64)  p(1:152)   p(1:152)

448 total header bits

d(1:64)  p(1:152)   d(1:64)  p(1:152)

## Fig. 12 (SC ex 3: different puncturing pattern)(eff. rate 1/7)

1200

EP 2 320 574 B1

Fig. 13 (SC ex 4: different puncturing pattern)(eff. rate 1/7)

Fig. 14 (SC ex 5: different puncturing pattern)(eff. rate 9/56)

EP 2 320 574 B1

Fig. 15  AWGN channel with QPSK SC PHY header

1500

**Fig. 16**

1600

Exp. decaying PDP Rayleigh channel with QPSK
SC PHY header

EP 2 320 574 B1

Fig. 17 (OFDM header encoding)(eff. rate K/N)

Fig. 18 (OFDM ex 1: no puncturing)(eff. rate 1/12)

header information bits (may be scrambled)

d(1:64)

padded bits (0-valued)(may be BPSK)

shortened

1900

d(1:64)

puncturing pattern 1 applied

d(1:64)    Z(65:504)

LDPC
encoder
circuitry
(rate 3/4)

d(1:64)

p(1:168)

puncturing pattern 1 applied

□ = non-punctured positions

Z(65:504)

p(1:168)

puncturing pattern 1 applied

▨ = punctured positions

p(1:168)

p(1:168)

puncturing pattern 1 applied

puncturing pattern 1 applied

puncturing pattern 1 applied

punc[1]    p(1:160) ▨    punc[1]=
punc[2]    p(1:160) ▨    punc[1]=
punc[2]=
punc[3]    p(1:160) ▨

p(1:160)    p(1:160)    p(1:160)

any desired means of combining bits to form header may be employed

3x repetition

| d(1:64) | d(1:64) | d(1:64) | p(1:160) | p(1:160) | p(1:160) |
|---|---|---|---|---|---|

672 OFDM header output

| d(1:64) | p(1:160) | d(1:64) | p(1:160) | d(1:64) | p(1:160) |
|---|---|---|---|---|---|

## Fig. 19 (OFDM ex 2: same puncturing pattern)(eff. rate 2/21)

EP 2 320 574 B1

Fig. 20 (OFDM ex 3: different puncturing pattern)(eff. rate 2/21)

EP 2 320 574 B1

Fig. 21 (OFDM ex 4: different puncturing pattern)(eff. rate 2/21)

EP 2 320 574 B1

Fig. 22 (OFDM ex 5: different puncturing pattern)(eff. rate 3/28)

**Fig. 23** AWGN channel with QPSK OFDM PHY header

SNR (dB)

2300

EP 2 320 574 B1

Exp. decaying PDP Rayleigh channel with QPSK
OFDM PHY header

**Fig. 24**

2400

SNR (dB)

BLER

Example 1, K=56
Offset rate loss on Example 1
Example 2, K=64
Example 3, K=64
Example 4, K=64
OFDM PHY
OFDM with exponentially-decaying PDP Rayleigh channel, QPSK

header information bits (may be scrambled)

c(1:64)

padded bits (0-valued)(may be BPSK)

shortened

2500

c(1:64)

c(1:64) | Z(1:440) → LDPC encoder circuitry (rate 3/4) → c(1:64) | Z(1:440) → c(1:64) | c(65:232)

c(65:232)

□ = non-punctured positions

▨ = punctured positions

puncture circuitry

puncturing pattern 1 applied:
punc[1]={63 64 217 218 219 220 221 222}

puncturing pattern 2 applied:
punc[2]={225 226 227 228 229 230 231 232}

punc[1] | c(1:62) ▨ c(65:216) ▨ | | punc[2] | c(1:64) | c(65:224) ▨ |

c{1:62} U c{65:216} U c{223:232}

c{1:224}

c(set1)

c(set2)

any desired means of combining bits to form header may be employed

combination | c(set1) | c(set2) |

448 total header bits

## Fig. 25 (SC ex 6: different puncturing pattern – incl. info. bits)(eff. rate K/N)

EP 2 320 574 B1

**Fig. 26** AWGN channel with QPSK SC PHY header (incl. puncturing info. bits)

2600

Legend:
- Example 1, K=56
- Offset rate loss on Example 1
- Example 4, K=64
- Example 5, K=64
  SC PHY, AWGN QPSK

Y-axis: BLER
X-axis: SNR (dB)

EP 2 320 574 B1

**Fig. 27** Exp. decaying PDP Rayleigh channel with QPSK SC PHY header (incl. puncturing info. bits)

2700

Legend:
- Example 1, K=56
- Offset rate loss on Example 1
- Example 4, K=64
- Example 5, K=64
- SC PHY
- OFDM with exponentially-decaying PDP Rayleigh channel, QPSK

Axis labels: BLER (vertical), SNR (dB) (horizontal)

EP 2 320 574 B1

**Fig. 28A**

2800

scrambling header information bits thereby generating scrambled header information bits 2810

padding at least one bit (e.g., 0-valued bits) to the scrambled header information bits thereby generating padded bit block 2820

encoding padded bit block thereby generating coded bits 2830

shortening coded bits (e.g., removing padded bits) thereby generating shortened coded bits 2840

puncturing at least one bit from the shortened coded bits thereby generating punctured bits 2850

spreading (e.g., combining, repeating, etc.) the punctured bits thereby generating header 2860

emplacing header within frame 2870

**Fig. 28B**

2801

duplicating at least one portion of coded bits (or shortened coded bits)(e.g., parity/redundancy bits of LDPC codeword) thereby generating duplicated bits 2811

puncturing, in accordance with a first puncturing pattern, at least one bit from the shortened coded bits thereby generating first punctured bits 2821

puncturing, in accordance with a second puncturing pattern, at least one bit from the shortened coded bits thereby generating second punctured bits 2831

spreading (e.g., combining, repeating, etc.) the first punctured bits and the second punctured bits thereby generating header 2841

emplacing header within frame 2851

**EP 2 320 574 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **R. GALLAGER.** Low-Density Parity-Check Codes. MIT Press, 1963
- **R. G. GALLAGER.** Low density parity check codes. *IRE Trans. Info. Theory,* January 1962, vol. IT-8, 21-28
- **M. G. LUBY ; M. MITZENMACHER ; M. A. SHOKROLLAHI ; D. A. SPIELMAN ; V. STEMANN.** Practical Loss-Resilient Codes. *Proc. 29th Symp. on Theory of Computing,* 1997, 150-159
- **T. J. RICHARDSON ; R. L. URBANKE.** The capacity of low-density parity-check code under message-passing decoding. *IEEE Trans. Inform. Theory,* February 2001, vol. 47 (2), 599-618